# EUROPEAN PATENT APPLICATION

(11) **EP 3 321 978 A1**
(43) Date of publication of application: **16.05.2018**
(21) Application number: 17200061.4
(22) Date of filing: 06.11.2017
(51) Int. Cl.: H01L 31/0747, H01L 31/0368, H01L 31/18

(54) **SOLAR CELL AND METHOD FOR MANUFACTURING THE SAME**

(30) Priority: 14.11.2016 KR 20160151121; 14.11.2016 KR 20160151130; 16.11.2016 KR 20160152667
(71) Applicant: LG Electronics Inc., SEOUL, 07336 (KR)
(72) Inventor: LEE, Yujin, 08592 Seoul (KR); KWON, Taein, 08592 Seoul (KR); JI, Kwangsun, 08592 Seoul (KR); LEE, Hongcheol, 08592 Seoul (KR)
(74) Representative: Frenkel, Matthias Alexander

(57) **Abstract**

Disclosed is a method for manufacturing a solar cell. The method includes: forming a first tunneling layer on one surface of a semiconductor substrate; forming a first conductive region on the first tunneling layer so that the first conductive region includes a metal oxide layer having an amorphous structure; and forming a first electrode electrically connected to the first conductive region.

## Description

### CROSS-REFERENCE TO RELATED APPLICATIONS

This application claims the priority benefit of Korean Patent Applications No. 10-2016-0151130, filed on November 14, 2016, No. 10-2016-0151121, filed on November 14, 2016, and No. 10-2016-0152667, filed on November 16, 2016, the disclosures of all of which are incorporated herein by reference in their entirety.

### BACKGROUND OF THE INVENTION

### Field of the Invention

Embodiments of the invention relate to a solar cell and a method for manufacturing the same, and, more particularly, to a solar cell including a metal oxide and a method for manufacturing the same.

### Description of the Related Art

Recently, as existing energy resources such as petroleum and coal are expected to be depleted, interest in alternative energy to replace them is increasing. Among them, solar cells are attracting attention as a next-generation battery that converts solar energy into electric energy.

Such a solar cell may be manufactured by forming various layers and various electrodes according to desired designs. In connection with this, efficiency of the solar cell may be determined according to designs of the various layers and electrodes. For commercial availability of such a solar cell, it is necessary to overcome problems associated with low efficiency of the solar cell. Accordingly, the various layers and the various electrodes are needed to be designed and manufactured in order to maximize the efficiency of the solar cell.

For example, in a conventional solar cell manufactured by doping a semiconductor substrate with a dopant, a doping process and the like are very complicated, and interfacial properties of the semiconductor substrate are deteriorated, resulting in poor passivation properties. In another solar cell manufactured without the doping process of the semiconductor substrate with the dopant in order to prevent this, properties and efficiency of the solar cell may be largely changed depending on the properties of a layer included in the solar cell and reliability of the solar cell is not high.

### SUMMARY OF THE INVENTION

Therefore, embodiments of the invention have been made in view of the above problems, and the invention is to provide a solar cell having excellent and uniform efficiency and properties and high productivity, and a method for manufacturing the solar cell.

A method for manufacturing a solar cell according to an embodiment of the invention includes: forming a first tunneling layer on one surface of a semiconductor substrate; forming a first conductive region on the first tunneling layer so that the first conductive region includes a metal oxide layer having an amorphous structure; and forming a first electrode electrically connected to the first conductive region.

A solar cell according to an embodiment of the invention includes: a semiconductor substrate; a tunneling layer on one surface of the semiconductor substrate; a first conductive region for extracting a first carrier on the tunneling layer and; and a first electrode electrically connected to the first conductive region, wherein the first conductive region includes a metal oxide layer having an amorphous structure. At least an interfacial portion of the first conductive region adjacent to the tunneling layer may be formed of an amorphous area where an amorphous portion having an amorphous structure is wider than a crystalline portion having a crystalline structure.

According to the embodiment, in a solar cell including a metal oxide layer as a conductive region, an interfacial portion of the conductive region is formed of an amorphous area, and thus, efficiency and reliability of the solar cell can be enhanced and productivity of the solar cell can be increased by a simple process.

In this instance, by differentiated compositions of a first portion and a second portion of the conductive type region, a passivation property in the first portion adjacent to the tunneling layer can be improved and thus open voltage and filling density of the solar cell can be improved, and also, an electrical property in the second portion adjacent to the electrode can be improved. Accordingly, efficiency of the solar cell can be enhanced. These first and second portions may have different compositions by varying process conditions. As a result, a solar cell having excellent properties and efficiency can be formed by a simple process.

In this instance, at least a part of a tunneling layer and a conductive region can be formed by an in-situ process to simplify the process more. In this instance, at least a part of the tunneling layer can be formed by the same method as the conductive type region even at a low temperature through using an ozone treatment. Thus, the in-situ process can be applied in forming of the tunneling layer and the forming of the conductive type region. As a result, a solar cell having excellent properties and efficiency can be formed by a simple process.

### BRIEF DESCRIPTION OF THE DRAWINGS

The above and other objects, features and other advantages of the invention will be more clearly understood from the following detailed description taken in conjunction with the accompanying drawings, in which:
FIG. 1 is a cross-sectional view of a solar cell according to an embodiment of the invention;
FIG. 2 is a front plan view of the solar cell shown in FIG. 1;
FIG. 3 shows a band diagram of a semiconductor substrate, a second tunneling layer, and a second conductive region in a solar cell according to an embodiment of the invention in (a), and a band diagram of the semiconductor substrate, a first tunneling layer, and a first conductive region in the solar cell according to the embodiment of the invention in (b);
FIG. 4 is a cross-sectional view of a solar cell according to a modified embodiment of the invention;
FIGS. 5A to 5C are cross-sectional views showing a method for manufacturing a solar cell according to an embodiment of the invention;
FIG. 6 is a cross-sectional view of a solar cell according to another embodiment of the invention;
FIG. 7 is a graph showing a ratio of oxygen to metal (oxygen/metal) and electrical conductivity in a binary metal oxide layer;
FIG. 8 is a measured result of bond energies in binary metal oxide layers in which ratios of oxygen to metal are different to each other by X-ray photoelectron spectroscopy;
FIG. 9 is a graph showing various variations of a ratio of oxygen to metal in a first conductive region of the solar cell shown in FIG. 6;
FIG. 10 is a cross-sectional view of a solar cell according to yet another embodiment of the invention;
FIG. 11 is a graph showing an x value of SiOx in a thickness direction of a first tunneling layer of the solar cell shown in FIG. 10;
FIG. 12 is a cross-sectional view of a solar cell according to another modified embodiment of the invention;
FIG. 13 is a diagram showing a reaction by an ozone treatment process during a formation of a first tunneling portion in a method for manufacturing the solar cell shown in FIG. 10;
FIG. 14 is a cross-sectional view of a solar cell according to yet another embodiment of the invention;
FIG. 15 is a cross-sectional view of a solar cell according to a modified embodiment of the embodiment shown FIG. 14;
FIG. 16 is a cross-sectional view of a solar cell according to yet still another embodiment of the invention;
FIG. 17 is a rear plan view of the solar cell shown in FIG. 16;
FIG. 18 are transmission electron microscope (TEM) photographs of solar cells, wherein (a) shows a TEM photograph of a solar cell according to Embodiment 1 and (b) shows a TEM photograph of a solar cell according to Comparative Example 2; and
FIG. 19 is a graph showing implied open-circuit voltages (implied Vocs) of the solar cells according to Embodiments 1, 5, and 6, and Comparative Example 3.

### DETAILED DESCRIPTION OF THE EMBODIMENTS

Reference will now be made in detail to various embodiments of the invention, examples of which are illustrated in accompanying drawings. The invention may, however, be embodied in many alternate forms and should not be construed as limited to the embodiments set forth herein.

In the drawings, illustration of parts unrelated to embodiments of the invention is omitted for clarity and simplicity of description. The same reference numerals designate the same or very similar elements throughout the specification. In the drawings, the thicknesses, widths or the like of elements are exaggerated or reduced for clarity of description, and should not be construed as limited to those illustrated in the drawings.

It will be understood that the terms "comprises" and/or "comprising," or "includes" and/or "including" used in the specification specify the presence of stated elements, but do not preclude the presence or addition of one or more other elements. In addition, it will be understood that, when an element such as a layer, film, region, or plate is referred to as being "on" another element, it may be directly disposed on another element or may be disposed such that an intervening element is also present therebetween. Accordingly, when an element such as a layer, film, region, or plate is disposed "directly on" another element, this means that there is no intervening element between the elements.

Also, hereinafter, terms "first" and "second" are used only for distinguishing each other, and the embodiments of the invention are not limited thereto.

Hereinafter, a solar cell and a method for manufacturing the same according to embodiments of the invention will be described in detail with reference to the accompanying drawings.

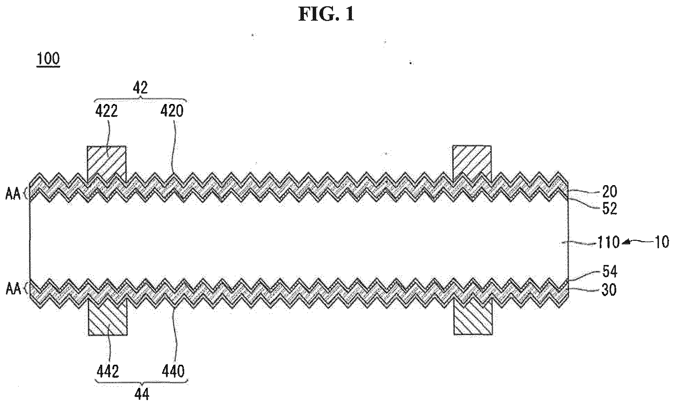

FIG. 1 is a cross-sectional view of a solar cell according to an embodiment of the invention.

Referring to FIG. 1, a solar cell 100 according to the embodiment includes a semiconductor substrate 10, a first tunneling layer 52 on a surface of the semiconductor substrate 10, a first conductive region 20 on the first tunneling layer 52, and a first electrode 42 electrically connected to the first conductive region 20. Also, the solar cell 100 may include a second conductive region 30 and a second electrode 44 connected to the second conductive region 30. In this instance, at least one of the first conductive region 20 and the second conductive region 30 includes or is formed of a metal oxide layer (for example, a binary metal oxide layer) having an amorphous structure. This will be explained in more detail.

The semiconductor substrate 10 may include a base region 110 having a first or second conductivity type. The base region 110 may have a first or second conductivity type dopant with a relatively low doping concentration. The base region 110 may be formed of a single crystalline semiconductor (e.g., a single-crystalline or polycrystalline semiconductor of a single material, such as a single-crystalline or polycrystalline silicon, more particularly, a single-crystalline silicon) including an n-type or p-type dopant. The solar cell 100 based on the semiconductor substrate 10 or the base region 110 having a high degree of crystallinity and having few defects has excellent electrical properties. In the embodiment, the semiconductor substrate 10 may be formed of only the base region 110 without a doped region formed by additional doping or the like. As a result, it is possible to prevent degradation of passivation properties of the semiconductor substrate 10 due to the doped region.

As an example, in the embodiment, the base region 110 may be doped with an n-type dopant to have an n-type. If the base region 110 has the n-type, a metal oxide layer (for example, a binary metal oxide layer) used as the first and second conductive regions 20 and 30 may be formed of a material that can be easily obtained and can be easily formed. Specific materials of the first and second conductive regions 20 and 30 will be described later in detail.

An anti-reflection structure capable of minimizing reflection may be formed on front and back surfaces of the semiconductor substrate 10. For example, a texturing structure having a concavo-convex shape in the form of a pyramid or the like may be provided as the anti-reflection structure. The texturing structure formed on the semiconductor substrate 10 may have a certain shape (e.g., a pyramid shape) having an outer surface formed along a specific crystal plane (e.g., (111) plane) of a semiconductor. When the surface roughness of the semiconductor substrate 10 is increased by forming concaves and convexes on the front surface and so on of the semiconductor substrate 10 by such texturing, the reflectivity of light incident into the semiconductor substrate 10 can be reduced to minimize the optical loss. However, the embodiments of the invention are not limited thereto. A texturing structure may be formed on only one surface of the semiconductor substrate 10, or a texturing structure may not be formed on the front and back surfaces of the semiconductor substrate 10.

The first tunneling layer 52 is formed on (e.g., is in contact with) the front surface of the semiconductor substrate 10. The first tunneling layer 52 acts as a kind of a barrier to electrons and holes so that minority carriers do not pass and only majority carriers having energy above a certain level can pass through the first tunneling layer 52 after the majority carriers are accumulated at a portion adjacent to the first tunneling layer 52. In this instance, the majority carriers having energy equal to or greater than the certain level can easily pass through the first tunneling layer 52 by a tunneling effect. The first tunneling layer 52 may improve passivation properties of the surface of the semiconductor substrate 10.

The first tunneling layer 52 may be formed entirely on the front surface of the semiconductor substrate 10. Accordingly, the first tunneling layer 52 can be easily formed without any additional patterning while having excellent passivation properties. The first tunneling layer 52 may be an undoped layer having no dopant. In the embodiment, since the first conductive region 20 is formed of a metal oxide layer not including the dopant and the first tunneling layer 52 may be relatively thick, the dopant included in the first conductive region 20 may be not diffused to the first tunneling layer 52 or the semiconductor substrate 10. Therefore, the first tunneling layer 52 may be formed as the undoped layer.

The first tunneling layer 52 may include any of various materials through which the majority carriers can be transferred by a tunneling. For example, the first tunneling layer 52 may include any of an oxide, a nitride, a semiconductor, a conductive polymer, and the like. For example, the first tunneling layer 52 may include a silicon oxide, a silicon nitride, a silicon oxynitride, a silicon carbide, an intrinsic amorphous semiconductor, an intrinsic polycrystalline semiconductor, and the like. In particular, the first tunneling layer 52 may be formed of a silicon oxide layer including a silicon oxide. This is because the silicon oxide layer is a layer which is excellent in passivation properties and through which the carrier can be easily transferred by the tunneling. Such a silicon oxide layer may be formed by a thermal oxidation or a chemical oxidation. Alternatively, the first tunneling layer 52 may be formed of an intrinsic amorphous silicon (i-a-Si) layer. Then, the first tunneling layer 52 includes the same material with the semiconductor substrate 10 and the first tunneling layer 52 has similar properties to the semiconductor substrate 10. Thus, the passivation properties can be improved more effectively. However, the embodiments of the invention are not limited thereto. Accordingly, the first tunneling layer 52 may be formed of an intrinsic amorphous silicon carbide (i-a-SiCx) layer or an intrinsic amorphous silicon oxide (i-a-SiOx) layer. According to this, the effect due to the wide energy band gap can be achieved, but the passivation property may be lower to some degrees than the embodiment including the intrinsic amorphous silicon (i-a-Si) layer.

The first conductive region 20 may be positioned on (e.g., be in contact with) the first tunneling layer 52. The first conductive region 20 may be formed entirely on the first tunneling layer 52. Accordingly, the first conductive region 20 has a sufficient area, and thus, an area contributing to the photoelectric conversion can be maximized. In the embodiment, the first conductive region 20 includes a metal oxide layer having an amorphous structure, which will be described later in more detail.

A thickness of the first tunneling layer 52 may be equal to, less than, or greater than a thickness of the first conductive region 20. In the embodiment, the first conductive region 20 may be formed of a metal oxide (for example, a binary metal oxide layer) having an amorphous structure, and the amorphous structure of the first conductive region 20 may be formed and maintained when the first conductive region 20 is thin. Accordingly, the first conductive region 20 has a small thickness in the embodiment, and thus, the thickness of the first tunneling layer 52 in not limited to be less than the thickness of the first conductive region 20. For example, when the thickness of the first conductive region 20 is minimized so that the first conductive region 20 has a more stable amorphous structure, the thickness of the first conductive region 20 may be equal to or less than the thickness of the first tunneling layer 52. As another example, when the thickness of the first tunneling layer 52 is reduced to maximize the tunneling effect through the first tunneling layer 52, the thickness of the first tunneling layer 52 may be less than the thickness of the first conductive region 20.

Alternatively, the thickness of the first tunneling layer 52 may be 10 nm or less, and the thickness of the first conductive region 20 may be 30 nm or less (for example, 10 nm or less). If the thickness of the first tunneling layer 52 exceeds 10 nm, the tunneling does not occur smoothly, and the solar cell 100 may not operate smoothly. If the thickness of the first conductive region 20 is greater than 30 nm, it may be difficult to have an amorphous structure and the carrier may not flow smoothly due to low electrical conductivity. In this instance, when the first conductive region 20 has a thickness of 10 nm or less, the amorphous structure of the first conductive region 20 can be stably maintained.

For example, the thickness of the first tunneling layer 52 may be 5 nm or less (more particularly, 2 nm or less, for example, 0.5 nm to 2 nm) in order to sufficiently realize the tunneling effect. If the thickness of the first tunneling layer 52 is less than 0.5 nm, it may be difficult to form the first tunneling layer 52 of desired quality. The first conductive region 20 may have the thickness of 2 nm or more (for example, 5 nm or more, as an example, 6 nm or more) so as to stably act as the conductive region. However, the embodiments of the invention are not limited thereto, and the thickness of the first tunneling layer 52 and/or the thickness of the first conductive region 20 may have any of various values.

The first electrode 42 may be formed on (e.g., be in contact with) the first conductive region 20 to be electrically connected to the first conductive region 20. For example, the first electrode 42 may include a first transparent electrode layer 420 and a first metal electrode layer 422 that are sequentially stacked on the first conductive region 20.

In this instance, the first transparent electrode layer 420 may be formed on (e.g., be in contact with) the first conductive region 20 to have a relatively large area. For example, the first transparent electrode layer 420 may be formed entirely on the first conductive region 20. When the first transparent electrode layer 420 is formed on the first conductive region 20 as described above, the carrier can easily reach the first metal electrode layer 422 through the first transparent electrode layer 420, and thus, resistance in a lateral direction can be reduced. In particular, in the embodiment, the first conductive region 20 is formed of an undoped metal compound layer that does not include a dopant, and thus, the resistance of the first conductive region may be increased. Therefore, the first transparent electrode layer 420 may be provided to effectively reduce the resistance.

As described above, since the first transparent electrode layer 420 is formed on the first conductive region 20 with a wide area, the first transparent electrode layer 420 may be formed of a light-transmitting material (a transparent material). That is, the first transparent electrode layer 420 may be formed of a transparent conductive material or a transparent conductive oxide so that the carrier can be easily moved while allowing transmission of light. Accordingly, even if the first transparent electrode layer 420 is formed on the first conductive region 20 with a large area, the transmission of light is not blocked. For example, the first transparent electrode layer 420 may include indium tin oxide (ITO), carbon nanotube (CNT), or the like. However, the embodiments of the invention are not limited thereto, and the first transparent electrode layer 420 may include any of various other materials.

The first metal electrode layer 422 may be formed on the first transparent electrode layer 420. For example, the first metal electrode layer 422 may be in contact with the first transparent electrode layer 420 to simplify the structure of the first electrode 42. However, the embodiments of the invention are not limited to this, and various modifications such as having a separate layer between the first transparent electrode layer 420 and the first metal electrode layer 422 are possible.

The first metal electrode layer 422 located on the first transparent electrode layer 420 may be formed of a material having electrical conductivity superior to that of the first transparent electrode layer 420. Thus, properties such as carrier collection efficiency can be further improved and the resistance can be effectively reduced by the first metal electrode layer 422. For example, the first metal electrode layer 422 may be formed of a material having an electrical conductivity higher than that of the first transparent electrode layer 420. The material of the first metal electrode layer 422 may be an opaque metal or a metal having transparency lower than that of the first transparent electrode layer 420.

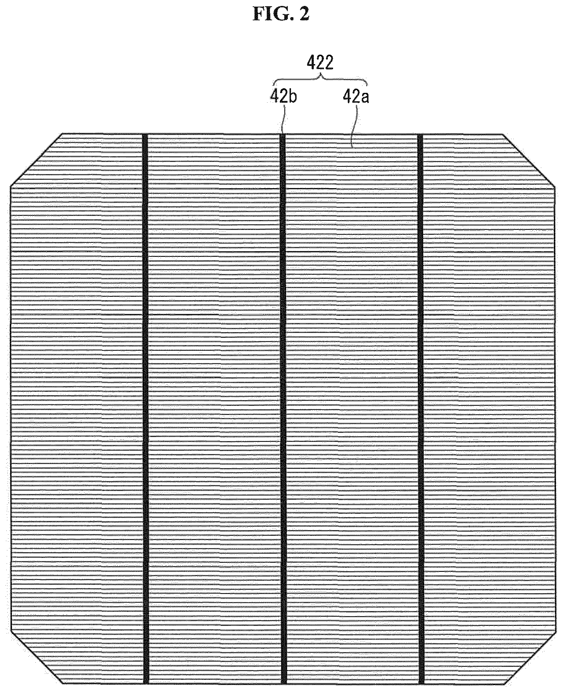

Since the first metal electrode layer 422 is opaque or has low transparency, it may interfere with the incidence of light, so that it may have a certain pattern so as to minimize shading loss. The first metal electrode layer 422 has a smaller area than the first transparent electrode layer 420. Thus, light can be incident on a portion where the first metal electrode layer 422 is not formed. A planar shape of the first metal electrode layer 422 will be described later in more detail with reference to FIG. 2.

In the embodiment, since the first metal electrode layer 422 is formed adjacent to or in contact with the first transparent electrode layer 420, a fire-through penetrating an insulating layer or the like is not required. The first metal electrode layer 422 may be formed by coating (e.g., by printing) a low-temperature-firing paste that can be fired at a low temperature (400°C or less, as an example, 350°C or less, for example, 300°C or less, as an example, 250°C or less) and heat-treating it.

The low-temperature-firing paste or the first metal electrode layer 422 formed by using the low-temperature-firing paste may not include a glass frit formed of a certain metal compound (for example, an oxide containing oxygen, a carbide containing carbon, a sulfide containing sulfur). The low-temperature-firing paste or the first metal electrode layer 422 may include only metal particles and a cross-linking resin, and other resins (for example, a curing agent, an additive). When the low-temperature-firing paste or the first metal electrode layer 422 does not include the glass frit, the metal particles of the first metal electrode layer 422 are not sintered. Instead, the first metal electrode layer 422 has the electrical conductivity since the low-temperature-firing paste is cured. In the curing process, the metal particles of the first metal electrode layer 422 are in contact with and aggregated with each other.

The metal particles may include any of various materials that provide the electrical conductivity. For example, the metal particles may include one selected from a group consisting of silver (Ag) particles, aluminum (Al) particles, copper (Cu) particles, or silver, aluminum, or copper particles coated with silver or tin (Sn), or include two or more particles selected from the above group and mixed to each other.

The cross-linking resin may include a material capable of performing cross-linking between the metals. In the embodiment, the first metal electrode layer 422 may be an electrode layer to which a solder layer for bonding a wiring material or the like is attached. The cross-linking resin may also prevent a penetration of the solder layer. Unlike the embodiment, if the cross-link resin is not included, the solder layer may penetrate into the first metal electrode layer 422 and the first metal electrode layer 422 may have brittleness, and thus, the first metal electrode layer 422 may be easily broken by a small impact or the like. It is expected that the cross-linking resin fills between the metal particles to prevent the penetration of the solder layer in the embodiment. For example, the cross-linking resin may include any of a phenoxy-based resin, an epoxy-based resin, a cellulose-based resin, and the like. They are excellent in cross-linking properties and do not change the properties of the electrodes. In particular, when the epoxy-based resin is used, excellent cross-linking properties can be obtained. In addition, the first metal electrode layer 422 may further include a curing agent. As the curing agent, an amine-based curing agent may be used. Examples of the amine-based curing agent may be any of phthalic anhydride, diethylamino propylamine, diethylene triamine, and the like. In addition, the other additives and the like may be included.

The low-temperature-firing paste for forming the first metal electrode layer 422 includes a solvent. However, the solvent may be volatilized during the heat treatment and may not be included in the first metal electrode layer 422 or may be included in a very small amount. As the solvent, an organic solvent may be used. For example, butyl carbitol acetate (BCA), cellulose acetate (CA) or the like may be used, but the embodiments of the invention are not limited thereto.

In this instance, an amount of a metal or an amount of metal particles may be greater than an amount of the cross-linking resin in the first metal electrode layer 422. Thus, the first metal electrode layer 422 can have sufficient electrical conductivity. For example, when a sum of the amount of the metal particles and the amount of the cross-linking resin is 100 parts by weight, the metal particles may be contained in an amount of 80 to 95 parts by weight, the cross-linking resin may be contained in an amount of 5 to 20 parts by weight, and the curing agent may be included in an amount of 0.1 to 5 parts by weight. The solvent may be contained in an amount of 3 to 10 parts by weight based on 100 parts by weight of the sum of the amount of the metal particles and the amount of the cross-linking resin before the heat treatment, but the solvent does not remain due to volatilization or only a trace amount of the solvent remains after the heat treatment. Since the amount of other materials such as the curing agent after heat treatment is not large, the weight of the metal or metal particles in the first metal electrode layer 422 may be 80 to 95 parts by weight.

If the amount of the metal particles is less than 80 parts by weight or the amount of the cross-linking resin exceeds 20 parts by weight, the electrical conductivity by the metal particles may not be sufficient. If the amount of the metal particles exceeds 95 parts by weight or the amount of the cross-linking resin is less than 5 parts by weight, the effect of preventing the penetration of the solder layer by the cross-linking resin may not be sufficient because the amount of the cross-linking resin is insufficient. The curing agent may be included in an amount such that sufficient curing can be achieved without deteriorating the properties of the low-temperature-firing paste. The solvent may be included in such an amount that uniformly mixes various materials and easily volatilized during the heat treatment so as not to deteriorate the electrical properties. However, the embodiments of the invention are not limited to these numerical values.

In the embodiment, the metal particles of one kind of particles may be used, or different metal particles having different shapes, particle sizes, materials, etc. may be mixed and used.

Hereinafter, an example of a planar shape of the first metal electrode layer 422 of the first electrode 42 will be described in detail with reference to FIGS. 1 and 2. FIG. 2 is a front plan view of the solar cell 100 shown in FIG. 1. For the simplicity, the first transparent electrode layer 420 of the first electrode 42 is not shown in FIG. 2.

Referring to FIG. 2, the first metal electrode layer 422 of the first electrode 42 may include a plurality of finger electrodes 42a spaced apart from each other with a predetermined pitch. Although the finger electrodes 42a are parallel to each other and parallel to an edge of the semiconductor substrate 10, the embodiments of the invention are not limited thereto. The first metal electrode layer 422 of the first electrode 42 may include a bus bar electrode 42b connecting the finger electrodes 42a in a direction crossing (for example, orthogonal to) the finger electrodes 42a. Only one bus bar electrode 42b may be provided or a plurality of bus bar electrodes 42b may be provided with a pitch larger than the pitch of the finger electrodes 42a as shown in FIG. 2. In this instance, a width of the bus bar electrode 42b may be larger than a width of the finger electrode 42a, but the embodiments of the invention are not limited thereto. Therefore, the width of the bus bar electrode 42b may be equal to or smaller than the width of the finger electrode 42a.

Referring to FIG. 1 again, a second tunneling layer 54 may be positioned on (e.g., be in contact with) the back surface of the semiconductor substrate 10, and the second conductive region 30 may be positioned on (e.g., be in contact with) the second tunneling layer 54. Also, the second electrode 44 electrically connected to the second conductive region 30 may be positioned on (e.g., be in contact with) the second conductive region 30. The second electrode 44 may include a second transparent electrode layer 440 and a second metal electrode layer 442 which are sequentially stacked on the second conductive region 30. Except that the second tunneling layer 54, the second conductive region 30, and the second electrode 44 are located on the back surface of the semiconductor substrate 10, the descriptions of the first tunneling layer 52, the first conductive region 20, and the second electrode 44 may be applied to them, respectively, as they are. However, the first conductive region 20 and the second conductive region 30 may be have different materials because the polarities of carriers extracted from the first conductive region 20 and the second conductive region 30 are different from each other. The first tunneling layer 52 and the second tunneling layer 54 may have the same thickness, shape, material, or the like, or may have different thicknesses, shapes, materials, and the like. The first transparent electrode layer 420 and/or the first metal electrode layer 422 and the second transparent electrode layer 440 and/or the second metal electrode layer 442 may have the same shape and/or material, and may have different shapes and/or materials. Widths and pitches of the finger electrodes 42a and the bus bar electrode 42b of the first metal electrode layer 422 may be the same as or different from widths and pitches of the finger electrodes and bus bar electrode of the second metal electrode layer 442, respectively. Alternatively, the planar shapes of the first metal electrode layer 422 and the second metal electrode layer 442 may be different from each other, or the stacked structures of the first electrode 42 and the second electrode 44 may be different from each other. Various other variations are possible.

In FIG. 1, an insulating layer such as a passivation film, an anti-reflection layer, a reflection layer, and the like may be further formed on the first and second conductive regions 20 and 30 and/or on the first and second transparent electrode layers 422 and 442.

In this instance, in the embodiment, at least one of the first and second conductive regions 20 and 30 is formed of a binary metal oxide layer having an amorphous structure. Hereinafter, it is exemplified that each of the first and second conductive regions 20 and 30 includes a binary metal oxide layer having an amorphous structure,

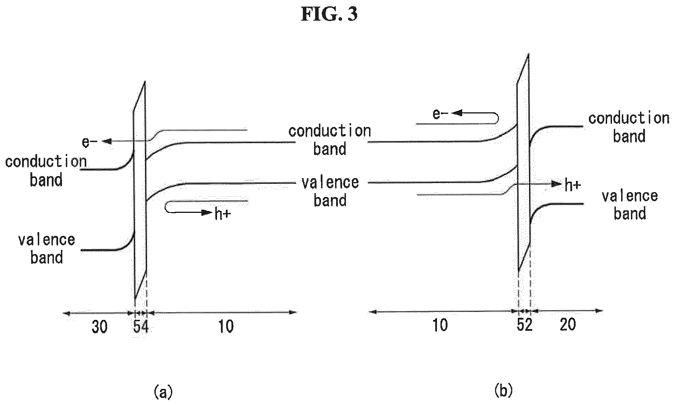

More particularly, each of the first conductive region 20 and the second conductive region 30 may include a metal compound being able to selectively extract and collect a first carrier or a second carrier (an electron or a hole) having different polarities in consideration of the energy band with respect to the semiconductor substrate 10. Accordingly, the first conductive region 20 and the second conductive region 30 do not include a semiconductor material, or a material that acts as a dopant in the semiconductor material. This will be described in more detail with reference to FIG. 3.

FIG. 3 shows a band diagram of the semiconductor substrate 10, the second tunneling layer 42, and the second conductive region 30 in the solar cell 100 according to the embodiment of the invention in (a), and a band diagram of the semiconductor substrate 10, the first tunneling layer 52, and the first conductive region 20 in the solar cell 100 according to the embodiment of the invention in (b).

Here, as described above, the semiconductor substrate 10 may be formed of the base region 110 having the n-type.

Referring to (a) and (b) of FIG. 3, in the embodiment, one of the first conductive region 20 and the second conductive region 30 extracts and collects the first carriers while the other of the first conductive region 20 and the second conductive region 30 extracts and collects the second carriers having an opposite polarity to that of the first carriers.

Hereinafter, it is exemplified that the first conductive region 20 extracts holes and the second conductive region 30 extracts electrons. According to this, the first conductive region 20 acts as an emitter region by extracting holes having an opposite polarity from electrons which are the majority carriers of the base region 110 of the n-type and, and the second conductive region 30 acts as a field region (a back surface field region) by extracting electrons which are the majority carriers of the base region 110 of the n-type. According to this, the first conductive region 20, which is located on the front surface of the semiconductor substrate 10 and acts as the emitter region that is substantially related to the photoelectric conversion, can effectively extract and collect the holes having a relatively low moving speed. However, the embodiments of the invention are not limited thereto. The first conductive region 20 positioned on the front surface of the semiconductor substrate 10 constitute a front electric field region for extracting electrons, and the second conductive region 30 positioned on the back surface of the semiconductor substrate 10 act as an emitter region for extracting holes.

More particularly, a binary metal compound layer constituting the first conductive region 20 capable of selectively extracting and collecting holes may have a Fermi level lower than a Fermi level of the semiconductor substrate 10, and may have a work function capable of obtaining a high open-circuit voltage and a low resistance while preventing a mismatch of the work function based on an electron affinity of 4.05 eV of the semiconductor substrate 10. For example, the work function of the first conductive region 20 may be 5.0 eV or more. If the work function is less than 5.0 eV, it may be difficult to selectively collect only holes except electrons.

When the first conductive region 20 formed of the metal compound layer having the Fermi level and the work function is bonded to the semiconductor substrate 10 while interposing the first tunneling layer 52 therebetween, the semiconductor substrate 10 and the first conductive region 20 are aligned and bonded so as to have the same Fermi level, as shown in (b) of FIG. 3. When the first conductive region 20 is bonded to the semiconductor substrate 10 as shown in (b) of FIG. 3, holes at a valence band of the semiconductor substrate 10 can be easily transferred to a valence band of the first conductive region 20 by passing through the first tunneling layer 52. On the other hand, electrons of the semiconductor substrate 10 do not pass through the first tunneling layer 52.

The binary metal compound layer that may be used for the first conductive region 20 may include a molybdenum oxide layer formed of a molybdenum oxide, a tungsten oxide layer formed of a tungsten oxide (e.g., WO₃), a vanadium oxide layer formed of a vanadium oxide, a nickel oxide layer formed of a nickel oxide, a rhenium oxide layer formed of a rhenium oxide, and the like. In particular, when the first conductive region 20 includes the molybdenum oxide layer or the tungsten oxide layer, the effect of selectively collecting holes may be excellent.

Also, a binary metal compound layer constituting the second conductive region 30 capable of selectively extracting and collecting electrons may have a Fermi level higher than a Fermi level of the semiconductor substrate 10, and may have a work function capable of obtaining a high open-circuit voltage and a low resistance while preventing a mismatch of the work function based on the electron affinity of 4.05 eV of the semiconductor substrate 10. For example, the work function of the second conductive region 30 may be 4.5 eV or less. If the work function is greater than 4.5 eV, it may be difficult to selectively collect only electrons.

When the second conductive region 30 formed of the metal compound layer having the Fermi level and the work function is bonded to the semiconductor substrate 10 while interposing the second tunneling layer 54 therebetween, the semiconductor substrate 10 and the second conductive region 30 are aligned and bonded so as to have the same Fermi lever, as shown in (a) of FIG. 3. When the second conductive region 30 is bonded to the semiconductor substrate 10 as shown in (a) of FIG. 3, electrons at a conduction band of the semiconductor substrate 10 can be easily transferred to a conduction band of the second conductive region 30 by passing through the second tunneling layer 54. On the other hand, the holes of the semiconductor substrate 10 do not pass through the second tunneling layer 54.

For example, the metal compound layer that may be used for the second conductive region 30 may include a titanium oxide layer formed of a titanium oxide (e.g., TiO₂), a zinc oxide layer formed of a zinc oxide (e.g., ZnO), and a niobium oxide layer formed of a niobium oxide (e.g., Nb₂O₅). In particular, when the second conductive region 30 includes the titanium oxide layer, the effect of selectively collecting electrons can be excellent.

The first and second conductive regions 20 and 30 having the binary metal oxide layer are formed of materials that can easily extract and collect the first or second carriers. Also, the first and second conductive regions 20 and 30 can prevent recombination, which may be induced by the dopant, and thus improve an open voltage. In addition, the loss due to light absorption can be reduced as compared with a doped region or a doped film, and a short circuit current density can be improved. Thus, efficiency of the solar cell 100 can be improved. In addition, the solar cell 100 can be manufactured by omitting a dopant doping process, a dopant activating process, and the like. In particular, since a high temperature process is not required, a process can be performed at a low temperature, thereby simplifying a manufacturing process and reducing manufacturing cost. Therefore, the productivity of the solar cell 100 can be improved.

In this instance, the first and second conductive regions 20 and 30, each formed of the binary metal oxide layer, in the embodiment have an amorphous structure. If the binary metal oxide layer has a crystalline structure, the passivation property is significantly lowered and the efficiency of the solar cell 100 is greatly lowered. The exact reason for this is not known, but this was confirmed experimentally. Although it is not clear, it is expected that an optical absorption at the binary metal oxide layer is greatly increased and thus a current loss is induced, and a surface roughness of the binary metal oxide layer is increased and it acts as surface defects, thereby increasing the recombination loss, when the crystal structure is included in the binary metal oxide layer with a large amount.

For example, an interfacial portion of the first and second conductive regions 20 and 30 adjacent to the first or second tunneling layer 52 or 54 may be formed of an amorphous area AA where an amorphous portion having an amorphous structure is wider than a crystalline portion having a crystalline structure. When the first and second conductive regions 20 and 30 have the above structures, sufficient passivation properties can be achieved. Particularly, when the amorphous area AA formed at the interfacial portion of the first and second conductive regions 20 and 30 adjacent to the first or second tunneling layers 52 or 54 has an amorphous structure as a whole, superior passivation property can be achieved. For example, an area ratio of the amorphous portion at the interfacial portion of the first and second conductive regions 20 and 30 adjacent to the first or second tunneling layer 52 or 54 may be 95% to 100% (for example, 99% to 100%). Within such a range, the solar cell 100 having the first and second conductive regions 20 and 30 of the binary metal oxide layers can have excellent efficiency.

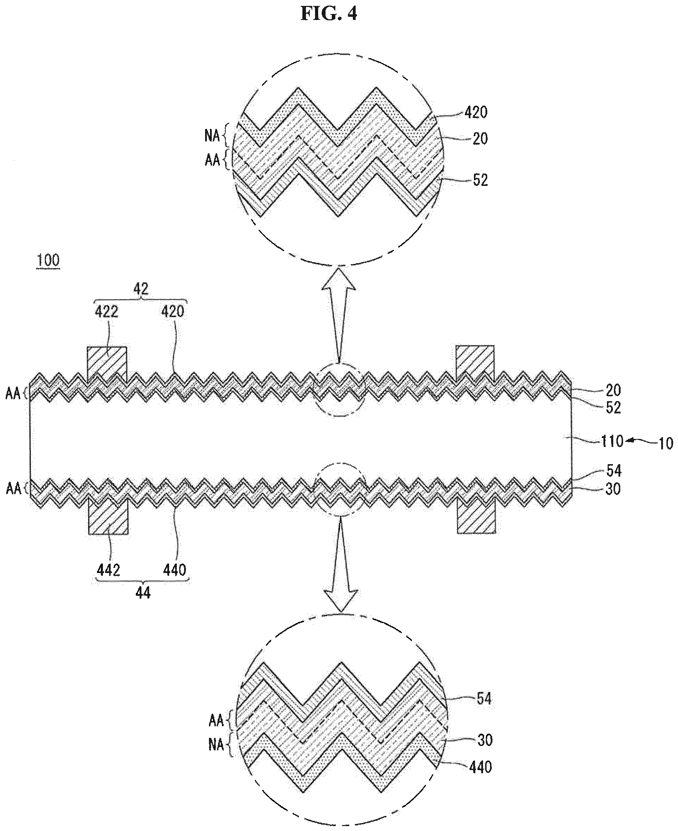

In the drawings, it is exemplified that the amorphous area AA is entirely formed in a thickness direction of the first and second conductive regions 20 and 30. However, the embodiments of the invention are not limited thereto. As another embodiment, as shown in FIG. 4, the amorphous area AA may be partially formed in the thickness direction of the first and/or the second conductive regions 20 and 30, and the amorphous area AA may be formed at a portion near the first or second tunneling layer 52 or 54, or the semiconductor substrate 10. In this instance, a ratio of a thickness of the amorphous area AA to a total thickness of the first or second conductive region 20 or 30 may be 0.2 or more (that is, 0.2 to 1), or the thickness of the amorphous area AA may be 1 nm or more. When the amorphous area AA having a thickness greater than a certain value (for example, the above ratio in the thicknesses of 0.2 or more or the thickness of 1 nm or more) is formed at the interfacial portion adjacent to the first or second tunneling layer 52 or 54, the passivation property can be sufficiently achieved. In the drawing, it is exemplified that a non-amorphous area NA having a crystalline portion wider than the crystalline portion of the amorphous area AA is entirely formed on the amorphous area AA. However, the embodiments of the invention are not limited thereto. The non-amorphous area NA may be partially formed in a plan view. The first and/or second conductive regions 20 and/or 30 of this structure may formed when process conditions of a forming process are unstable to some degrees or when process conditions of a subsequent process are unstable to some degrees. However, the embodiments of the invention are not limited thereto, and the first and/or second conductive regions 20 and/or 30 of this structure may be formed by intentionally controlling the process conditions. Because the non-amorphous area NA may have the crystalline portion with a large area, the carrier mobility can be enhanced, and thus, the efficiency of transferring the carrier to the first or second electrode 42 or 44 can be improved.

In the above descriptions and drawings, it is exemplified that each of the first and second conductive regions 20 and 30 is made of the binary metal compound layer. However, the embodiments of the invention are not limited thereto, and only one of the first and second conductive regions 20 and 30 may be formed of the above-described binary metal compound layer. Various other variations are possible.

When light is incident on the solar cell 100 according to the embodiment, electrons and holes are generated by photoelectric conversion. One of the generated holes and electrons is tunneled through the first tunneling layer 52, is transferred to the first conductive region 20, and then, to the first electrode 42. The other one of the generated holes and electrons is tunneled through the second tunneling layer 54, is transferred to the second conductive region 30, and then, to the second electrode 44. The holes and electrons transferred to the first and second electrodes 42 and 44 move to an external circuit or another solar cell 100, thereby generating electrical energy.

In this instance, in the embodiment, the first and second metal electrode layers 422 and 442 of the solar cell 100 have a certain pattern, and thus, the solar cell 100 has a bi-facial structure being able to receive light from the front surface and the back surface of the semiconductor substrate 10. Accordingly, the amount of light used in the solar cell 100 can be increased and the efficiency of the solar cell 100 can be enhanced. However, the embodiments of the invention are not limited thereto.

Since the first and second conductive regions 20 and 30 are formed on the semiconductor substrate 10 while interposing the first or second tunneling layer 52 or 54 therebetween, they are separate layers from the semiconductor substrate 10. As a result, the loss due to the recombination can be minimized as compared with the instance where the doped region formed by doping the semiconductor substrate 10 with the dopant is used as the conductive region. In particular, the first and second conductive regions 20 and 30 are formed of the binary metal oxide layer that does not contain a semiconductor material and a dopant, and therefore, the open-circuit voltage and the short-circuit current density of the solar cell 100 can be enhanced and the manufacturing process of the first and second conductive regions 20 and 30 can be simplified. Thus, efficiency and productivity of the solar cell 100 can be improved.

Particularly, the interfacial portion of at least one of the first and second conductive regions 20 and 30 is formed of the amorphous area AA, and thus, efficiency of the solar cell 100 including the binary metal oxide layer can be improved.

The solar cell 100 including the first and second conductive regions 20 and 30 having the amorphous areas AA as described above may be formed by any of various manufacturing methods. Hereinafter, a method for manufacturing a solar cell 100 according to an embodiment will be described in detail.

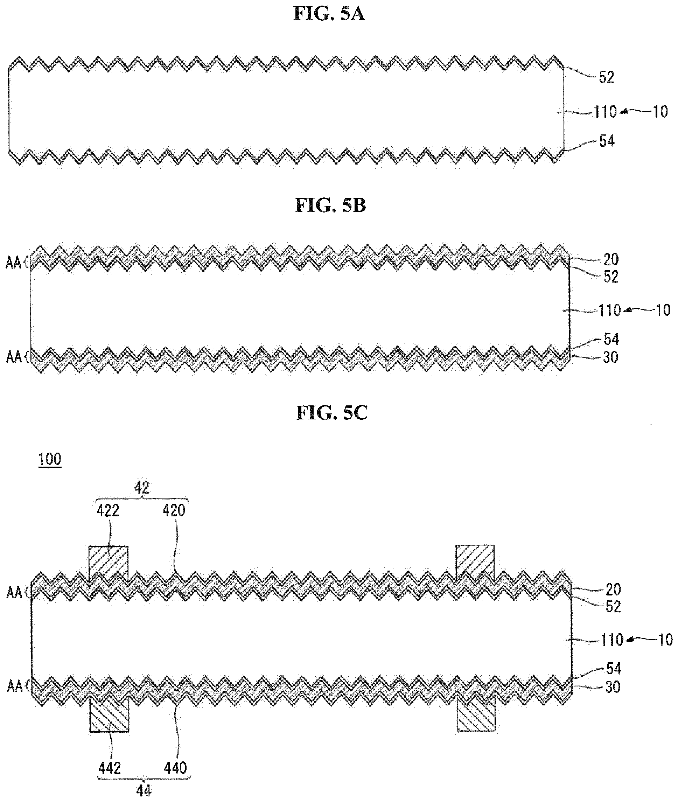

Hereinafter, a method for manufacturing a solar cell 100 according to an embodiment of the invention will be described in detail with reference to FIGS. 5A to 5C. FIGS. 5A to 5C are cross-sectional views illustrating a method for manufacturing a solar cell 100 according to an embodiment of the invention.

As shown in FIG. 5A, first and second tunneling layers 52 and 54 are formed on a front surface and a back surface of the semiconductor substrate 10, respectively. For example, the first tunneling layer 52 positioned on the front surface of the semiconductor substrate 10 and the second tunneling layer 54 positioned on the back surface of the semiconductor substrate 10 may be simultaneously formed in the same process. This can simplify the manufacturing process. However, the embodiments of the invention are not limited thereto, and the first tunneling layer 52 and the second tunneling layer 54 may be formed by different processes.

The first and second tunneling layers 52 and 54 may be formed by a thermal growth, a deposition (e.g., a chemical vapor deposition (PECVD), an atomic layer deposition (ALD)), a chemical oxidation, or the like. However, the embodiments of the invention are not limited thereto, and the first and second tunneling layers 52 and 54 may be formed by any of various methods.

In this instance, the semiconductor substrate 10 having the front surface and/or the back surface textured to have an anti-reflection structure may be used for the semiconductor substrate 10. Texturing of the surface of the semiconductor substrate 10 may be performed by a wet or dry texturing. The wet texturing may be performed by immersing the semiconductor substrate 10 in a texturing solution, and has an advantage of a short process time. In the dry texturing, the surface of the semiconductor substrate 10 may be cut by using a diamond grill, a laser, or the like. According to the dry texturing, the anti-reflection structure is uniformly formed, but the processing time is long and damage to the semiconductor substrate 10 may occur. Alternatively, the semiconductor substrate 10 may be textured by reactive ion etching (RIE) or the like. As described above, the semiconductor substrate 10 may be textured in any of various methods in the invention.

Next, as shown in FIG. 5B, a first conductive region 20 is formed on the first tunneling layer 52 and a second conductive region 30 is formed on the second tunneling layer 54. In the embodiment, each of the first conductive region 20 and the second conductive region 30 (hereinafter, referred to as the conductive regions 20 and 30) formed of the binary metal oxide layer having an amorphous structure. Particularly, in the embodiment, at least an interfacial portion of the conductive regions 20 and 30 adjacent to the first tunneling layer 52 or the second tunneling layer 54 (hereinafter, referred to as the tunneling layer 52 or 54) includes an amorphous area AA. Since a phase change of the binary metal oxide layer may be easily induced depending on the process conditions and the electrical and optical properties of the binary metal oxide layer may be greatly changed by the phase of the metal oxide layer, the conductive regions 20 and 30 must be formed by a specific manufacturing process. This will be described in detail below.

In the embodiment, the conductive regions 20 and 30 may be formed by any suitable process such as an atomic layer deposition (ALD), a physical vapor deposition (PVD), an e-beam evaporation, sputtering, or a chemical vapor deposition (CVD).

For example, in the atomic layer deposition process, by repeatedly injecting a first raw material including oxygen and a second raw material including a metal and purging the first raw material or the second raw material therebetween, the deposition of each layers of the conductive regions 20 and 30 is performed. An oxygen gas, ozone, water, or the like may be used as the first raw material, and a metal compound including a metal may be used as the second raw material. Since the atomic layer deposition process is performed on a layer-by-layer basis, a crystal structure of the conductive regions 20 and 30 can be easily controlled by adjusting a process temperature, and thus, a desired amorphous structure (particularly, an amorphous area (AA)) can easily be formed. As the physical vapor deposition, sputtering or evaporation may be used. Particularly, the evaporation may be performed at a room temperature, and therefore, the conductive regions 20 and 30 having an amorphous structure can be easily formed at a room temperature.

In particular, by using the atomic layer deposition process, thin and uniform conductive regions 20 and 30 can be formed on the semiconductor substrate 10 having an anti-reflection structure, and the mass productivity is also excellent.

More particularly, if the process temperature of the atomic layer deposition process or the physical vapor deposition process is high, the binary metal oxide is bonded to the tunneling layer 52 or 54, or other layer formed before the conductivity regions 20 and 30 by a sufficient energy, and thus, the conductivity regions 20 and 30 may be have a crystalline structure. On the other hand, when the process temperature is low, the conductivity regions 20 and 30 may have an amorphous structure.

The process temperature of the atomic layer deposition process may be 250°C or less. When the process temperature of the atomic layer deposition process is 250°C or less, the conductive regions 20 and 30 may include the amorphous area AA where an amorphous portion is widely formed (e.g., the amorphous portion is entirely formed) at an interfacial portion adjacent to the tunneling layer 52 or 54. The process temperature of the atomic layer deposition process may be 100°C or more (e.g., 150°C or more). If the process temperature is less than 100°C, the conductive regions 20 and 30 may be porous, which may degrade the properties of extracting and delivering a desired carrier. Alternatively, the process temperature of the physical vapor deposition process may be from a room temperature to 250°C (e.g., 5 to 250 °C, for example, 5 to 150°C). This is because the conductive regions 20 and 30 are formed stably at this temperature to have the amorphous area AA.

In this instance, the process temperature may be slightly changed depending on materials constituting the conductive regions 20 and 30 within the above-mentioned process temperature range. This is because a process margin may vary depending on a material of an oxide.

Also, if thicknesses of the conductive regions 20 and 30 exceed a certain level, a crystal structure may be changed or a defect density may be increased gradually or during a subsequent heat-treatment process, and thus, the passivation property may be deteriorated, even if the deposition is performed by the atomic layer deposition process at the low process temperature. Accordingly, thicknesses of the conductive regions 20 and 30 formed by the atomic layer deposition process may be 50nm or less (for example, 30 nm or less). Accordingly, a number of cycles can be reduced and thus a process time can be reduced, and the conductive regions 20 and 30 having a desired phase can be stably formed. These thicknesses may vary depending on materials of the oxide layer constituting the conductive regions 20 and 30, for example, the thicknesses of the conductive regions 20 and 30 may be 15 nm or less. Alternatively, when the second conductive region 30 is formed of a molybdenum oxide layer having lots of defects, the second conductive region 30 may have a thickness the same as or smaller than (particularly, smaller than) that of the first conductive region 20 formed of another oxide layer.

For example, the thicknesses of the conductive regions 20 and 30 may be 2 nm or more (for example, 5 nm or more, as an example 6 nm or more). If the thicknesses of the conductive regions 20 and 30 are less than the certain value, the properties of the conductive regions 20 and 30 may be changed due to a first or second transparent electrode layer 420 or 440 located on the conductive regions 20 and 30, and thus, the surface recombination properties may be deteriorated. In addition, one of the conductive regions 20 and 30 for extracting electrons (for example, the second conductive region 30) may sufficiently extract and deliver the electrons only when it has a thickness of a certain thickness or more. Because the passivation effect by a surface field region is insufficient when the one of the conductive regions 20 and 30 for extracting the electrons is bonded to the semiconductor substrate 10 of the n-type, the one of the conductive regions 20 and 30 for extracting the electrons is difficult to sufficiently extract the electrons if its thickness is thin. However, the embodiments of the invention are not limited thereto.

In the embodiment, the second conductive region 30 may be formed after the first conductive region 20 is formed, or the first conductive region 20 may be formed after the second conductive region 30 is formed.

For example, when a first process temperature for forming the first conductive region 20 and a second process temperature for forming the second conductive region 30 are different from each other, one of the first and second conductive regions 20 and 30, which is formed at a relatively high process temperature, is firstly formed and then, the other of the first and second conductive regions 20 and 30, which is formed at a relatively low process temperature, is formed. That is, if the first process temperature is higher than the second process temperature, the second conductive region 30 is formed after forming the first conductive region 20. If the second process temperature is higher than the first process temperature, the first conductive region 20 is formed after forming the second conductive region 30. If the process at the relatively low temperature is firstly performed and then the process at the relatively high temperature is performed, properties of a material formed by the process at the relatively low temperature may be deteriorated or the material formed by the process at the relatively low temperature may be crystallized during the process at the relatively high temperature. Thus, the embodiment is for preventing them. For example, when the first conductive region 20 is formed of a molybdenum oxide layer and the second conductive region 30 is formed of a titanium oxide layer, the second conductive region 30 is firstly formed, and then, the first conductive region 20 is formed. This is because the process margin for the process temperature is slightly smaller in the molybdenum oxide layer than in the titanium oxide layer so that the molybdenum oxide layer may have a lower process temperature. However, the embodiments of the invention are not limited thereto.

In the above descriptions and the drawings, it is exemplified that the first and second tunneling layers 52 and 54 are formed, and then, the first and second conductive regions 20 and 30 are formed. However, the embodiments of the invention are not limited thereto. The first tunneling layer 52, the first conductive region 20, the second tunneling layer 54, and the second conductive region 30 may be sequentially formed, or the second tunneling layer 54, the second conductive region 30, the first tunneling layer 52, and the first conductive region 20 may be sequentially formed.

Also, it is exemplified that each of the first and second conductive regions 20 and 30 is formed of the binary metal oxide layer in the above description and the drawings, any one of the first and second conductive regions 20 and 30 may be a doped region formed on the substrate 10 or a semiconductor layer separately formed on the semiconductor substrate 10. In this instance, the tunneling layer 52 or 54 corresponding to the conductive region 20 or 30 not formed of the binary metal oxide layer may be provided or may not be provided. In this instance, the doped region may be formed at the semiconductor substrate 10 by a doping process such as an ion implantation, a thermal diffusion, or laser doping. The semiconductor layer may be formed by a method such as a deposition. The doping of the semiconductor layer may be performed together with the deposition of the semiconductor layer or may be performed by a separate doping process after the deposition of the semiconductor layer. Various other methods may also be used.

Next, as shown in FIG. 5C, a first electrode 42 electrically connected to the first conductive region 20 and a second electrode 44 electrically connected to the second conductive region 30 are formed.

For example, a first transparent electrode layer 420 and a second transparent electrode layer 440 may be formed by, for example, a vapor deposition method (for example, chemical vapor deposition (PECVD) method), a coating method, or the like. In this instance, the first transparent electrode layer 420 and the second transparent electrode layer 440 may be formed simultaneously to simplify the manufacturing process. However, the embodiments of the invention are not limited thereto, and the first and second transparent electrode layers 420 and 440 may be formed by any of various methods.

A first metal electrode layer 422 and a second metal electrode layer 442 may be formed by plating, printing, or the like. For example, the first metal electrode layer 422 and the second metal electrode layer 442 may be formed by printing a low-temperature firing paste and then drying or firing the same. The low-temperature firing paste was described in detail in the above descriptions of the first metal electrode layer 422, and thus, the detailed descriptions thereof will be omitted. In this instance, the first metal electrode layer 422 and the second metal electrode layer 442 may be formed by the same process, thereby simplifying the manufacturing process. However, the embodiments of the invention are not limited thereto, and the first and second metal electrode layers 422 and 442 may be formed by any of various methods.

Accordingly, in the embodiment, the step of forming the first and/or second electrodes 42 and 44 may be performed at a process temperature of 350°C or less (for example, 300°C or less, for example, 250°C or less). Also, all steps performed after the step of forming the conductive regions 20 and 30 may be performed at a process temperature of 350°C or less (for example, 300°C or less, for example, 250°C or less). By the temperature, the amorphous structure or the amorphous area AA of the conductive regions 20 and 30 can be maintained in a final structure without being crystallized.

According to this embodiment, the conductive region 20 or 30 formed of the binary metal oxide layer having the amorphous structure can be formed by a simple process. Thus, the solar cell 100 having excellent properties and efficiency can be formed by a simple process.

Hereinafter, a solar cell according to another embodiment of the invention will be described in detail. Detailed descriptions will be omitted for the same or extremely similar parts as those described above, and only different parts will be described in detail. It is also within the scope of the invention to combine the above-described embodiments or variations thereof with the following embodiments or modifications thereof.

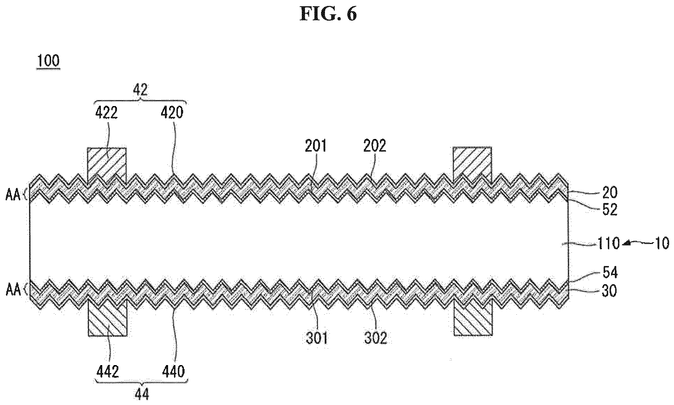

FIG. 6 is a cross-sectional view of a solar cell according to another embodiment of the invention.

Referring to FIG. 6, at least one of a first conductive region 20 and a second conductive region 30 includes a first portion 201 or 301 and a second portion 202 or 302. Each of the first portion 201 or 301 and the second portion 202 or 302 includes a metal oxide layer (for example, a binary metal oxide layer) while the first portion 201 or 301 and the second portion 202 or 302 have compositions different from each other.

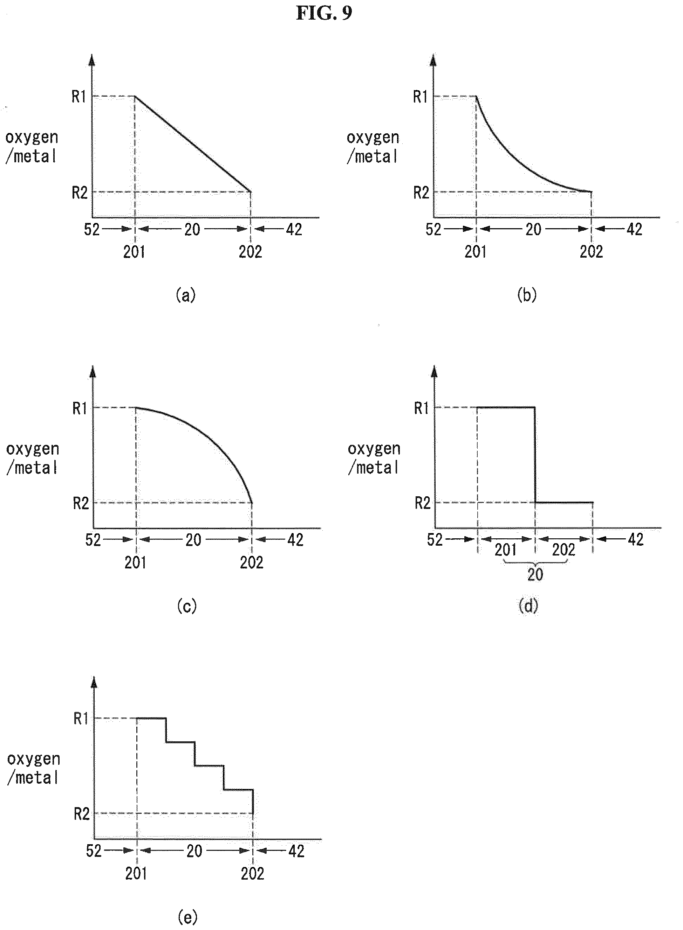

That is, the first portion 201 adjacent to a first tunneling layer 52 in the first conductive region 20 and the second portion 202 adjacent to a first electrode 42 to be opposite to the first portion 201 have different compositions. In this instance, a first oxygen ratio R1 (refer to FIG. 9) which is a ratio of oxygen to metal (more particularly, a ratio of a number of oxygen atoms to a number of metal atoms) in the first portion 201 is different from a second oxygen ratio R2 (refer to FIG. 9) which is a ratio of oxygen to metal in the second portion 202. The ratio of oxygen to metal or the composition of the first conductive region 20 may be measured by any of various composition analysis methods, such as, energy dispersive X-ray spectroscopy (EDS), Rutherford backscattering spectrometry (RBS), elastic recoil detection (ERD), secondary ion mass spectrometry (SIMS), Auger electron spectroscopy, and X-ray photoelectron spectroscopy (XPS).

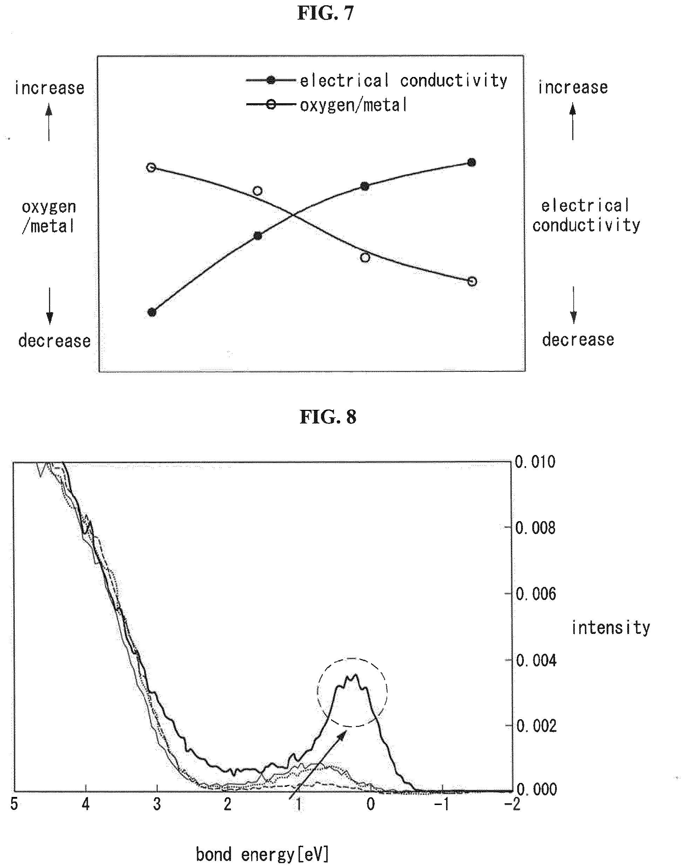

More specifically, the second oxygen ratio R2 of the second portion 202 may be less than the first oxygen ratio R1 of the first portion 201. Even in the instance of the same binary metal oxide, the properties of the first conductive region 20 may vary depending on the ratio of oxygen to metal. This will be described in detail with reference to FIGS. 7 and 8.

FIG. 7 is a graph showing a ratio of oxygen to metal (oxygen/metal) and electrical conductivity in a binary metal oxide layer, and FIG. 8 is a measured result of bond energies in binary metal oxide layers in which ratios of oxygen to metal are different each other by X-ray photoelectron spectroscopy.

Referring to FIG. 7, it can be seen that electrical conductivity is low when the ratio of oxygen to metal is high, and electrical conductivity is high when the ratio of oxygen to metal is low due to a high heat treatment temperature. Oxygen vacancies are generates when the oxygen ratio to metal is lower than a stoichiometric value of the metal oxide. Since the oxygen vacancies are positions where carriers are moved, the electric conductivity increases when the oxygen vacancies are increased. Accordingly, it can be seen that the electrical conductivity is low when the ratio of oxygen to metal is high, while the electrical conductivity is high when the ratio of oxygen to metal is low.

Referring to Fig. 8, the ratio of oxygen to metal decreases in a direction of an arrow. In the instance where a defect exists in the metal oxide, photoelectron absorption occurs in a low energy region below a band gap energy, resulting in a peak. The peak does not appear in a low energy region when the ratio of oxygen to metal is high, whereas the peak occurs in a low energy region (for example, 0 eV) when the oxygen ratio to metal is low, as shown in the circle of the dotted line. Accordingly, if the ratio of oxygen to metal is lower than the stoichiometric value, defects may increase in the layer and the passivation properties may be deteriorated.

That is, when the ratio of oxygen to the metal is low in the first conductive region 20, the electrical conductivity is high while the passivation properties may be deteriorated due to defects. On the contrary, when the ratio of oxygen to the metal is high, the passivation properties are enhanced while electrical conductivity is low.

Considering this, the first oxygen ratio (R1) of the first portion 201 adjacent to the first tunneling layer 52 in the first conductive region 20 may be relatively high to reduce the interface defect, thereby improving the passivation properties. The second oxygen ratio R2 of the second portion 202 adjacent to the first electrode 42 may be relatively low to effectively extract the carrier and to minimize the contact resistance with the first electrode 42.

In this instance, the difference (R1-R2) between the first oxygen ratio R1 of the first portion 201 and the second oxygen ratio R2 of the second portion 202 may be 1 or less. For example, the difference (R1-R2) may be 0.1 or more. If the difference (R1-R2) is greater than 1, the second oxygen ratio R2 of the second portion 202 may be significantly lowered, and thus, the passivation properties of the first conductive region 20 may be lowered as a whole. If the difference (R1-R2) is less than 0.1, the difference in the ratio of oxygen to metal is not large, and the effect may not be exhibited or be apparent.

Further, the first portion 201 having a large ratio of oxygen to metal may have a higher band gap and a lower refractive index than the second portion 202 having a small ratio of oxygen to metal. The light absorption loss can be reduced by the first portion 201 having the high band gap and the low refractive index.

Also, it has a tendency that the ratio of oxygen to metal decreases from the first portion 201 to the second portion 202 between the first portion 201 and the second portion 202 in the first conductive region 20. The ratio of oxygen to metal between the first portion 201 and the second portion 202 may be varied in any of various manners. This will be described with reference to FIG. 9. FIG. 9 is a graph showing various variations of the ratio of oxygen to metal in the first conductive region 20 of the solar cell 100 according to the embodiment of the invention.

The ratio of oxygen to metal may gradually decrease from the first portion 201 to the second portion 202 as shown in (a) to (c) of FIGS. 9. As an example, the ratio of oxygen to metal may decrease linearly from the first portion 201 to the second portion 202, as shown in (a) of FIG. 9. Alternatively, as shown in (b) of FIG. 9, the ratio of oxygen to metal decreases from the first portion 201 toward the second portion 202 while a decreasing ratio (i.e., a slope in the graph of FIG. 9) may gradually decrease as it goes toward the second portion 202. Alternatively, as shown in (c) of FIG. 9, the ratio of oxygen to metal decreases from the first portion 201 toward the second portion 202 while a decreasing ratio (i.e., a slope in the graph of FIG. 9) may gradually increase as it goes toward the second portion 202.

Alternatively, as shown in (d) and (e) of FIG. 9, the ratio of oxygen to metal may decrease from the first portion 201 to the second portion 202 to have steps. That is, a plurality of regions having a constant ratio of oxygen to metal are provided, and the plurality of regions are arranged from the first portion 201 to the second portion 202 such that the ratio of oxygen to metal gradually decreases. For example, as shown in (d) of FIG. 9, the first conductive region 20 is formed by stacking the first portion 201 having a uniform first oxygen ratio R1 and the second portion 202 having a uniform second oxygen ratio R2. For example, a thickness of the first portion 201 having a high band gap and a low refractive index may be equal to or greater than that of the second portion 202 to minimize optical loss. However, the embodiments of the invention are not limited thereto, and the thickness of the first portion 201 may be smaller than that of the second portion 202. Alternatively, as shown in (e) of FIG. 9, the first conductive region 20 may have three or more portions having a uniform ratio of oxygen to metal, and the ratio of oxygen to metal may decrease in the three or more portions of the first conductive region 20 toward the second portion 202.

In addition, although there is no specific tendency to be found, the ratio of oxygen to metal may decrease from the first portion 201 to the second portion 202 in various ways, which is also included in the embodiments of invention.

Similarly, in the second conductive region 30, the first portion 301 adjacent the second tunneling layer 54 and the second portion 302 adjacent to the second electrode 44 to be opposite to the first portion 301 have different compositions from each other. The descriptions of the first portion 201 and the second portion 202 of the first conductive region 20 may be applied to the first portion 301 and the second portion 302 the second conductive region 30 as they are, except that the first portion 301 and the second portion 302 of the second conductive region 30 are formed of different binary metal oxide from a binary metal oxide of the first portion 201 and the second portion 202 of the first conductive region 20. In this instance, a difference between a first oxygen ratio which is a ratio of oxygen to metal in the first portion 301 and a second oxygen ratio which is a ratio of oxygen to metal in the second portion 302 may be 1 or less (for example, 0.1 to 1).

It is exemplified that the first and second conductive regions 20 and 30 are all formed of a binary metal compound layer and include the first and second portions 201 and 301 and the second portions 202 and 302 in the above descriptions and the drawings. However, the embodiments of the invention are not limited thereto. Only one of the first and second conductive regions 20 and 30 may be composed of the above-described binary metal compound layer, and only one of the first and second conductive regions 20 and 30 may include the first and second portion 201 and 301 or 202 and 302 having different compositions. In one example, the first portion 201 and the second portion 202 of the first conductive region 20 have different ratios of oxygen to metal and the first portion 301 and the second portion 302 of the second conductive region 30 may have the same ratio of oxygen to metal. According to this, connection properties of the first conductive region 20 with the first electrode 42 positioned on the front surface of the solar cell 100 can be improved, and thus, a line width of the first metal electrode layer 422 of the first electrode 42 can be decreases to reduce the light loss. Various other variations are possible. Also, by differentiated compositions of the first portion 201 or 301 and the second portion 202 or 302 of the first or second conductive type region 20 or 30, a passivation property in the first portion 201 or 301 adjacent to the tunneling layer 52 or 54 can be improved and thus open voltage and filling density of the solar cell 100 can be improved, and also, an electrical property in the second portion 202 or 302 adjacent to the electrode 42 or 44 can be improved. Accordingly, efficiency of the solar cell 100 can be enhanced more.

The conductive region 20 or 30 having the first portion 201 or 301 and the second portion 202 or 302 is formed by controlling a process condition in a process of forming the conductive region 20 or 30 shown in FIG. 5B. That is, in the embodiment, the conductive region 20 or 30 is formed to have the first portion 201 or 301 and the second portion 202 or 302 having different compositions in the process of forming the conductive region 20 or 30. This may be achieved by differentiating a process condition of the first portion 201 or 301 and a process condition of the second portion 202 or 302. That is, in the process of forming the conductive region 20 or 30, the process condition of an initial process of the conductive region 20 or 30 (that is, a process of forming the first portion 201 or 301) (hereinafter, referred to as a first process) may be different from the process condition of a later process of the conductive region 20 or 30 (that is, a process of forming the second portion 202 or 302) (hereinafter, referred to as a second process). In some embodiments, at least one process having a process condition different from the process conditions of the first and second processes may be performed between the first process and the second process. Hereinafter, an embodiment using an atomic layer deposition will be described as an example.

In one example, a supply time (each supply time or a total supply time) of a first raw material containing oxygen and/or a supply time (each supply time or a total supply time) of a second raw material containing a metal may be varied. That is, the first raw material is supplied for a first process time in the first process, while and the first raw material is supplied for a second process time shorter than the first process time. And/or, the second raw material is supplied for a third process time in the first process, while and the second raw material is supplied for a fourth process time longer than the third process time. Then, the ratio of oxygen to metal in the second portion 202 or 302 formed in the second process is lower than that in the first portion 201 or 301 formed in the first process.

Alternatively, a supply amount (or a concentration) of the first raw material containing the oxygen and/or a supply amount (or a concentration) of the second raw material containing the metal may be different. That is, the first raw material is supplied with a first supply amount in the first process, while and the first raw material is supplied with a second supply amount smaller than the first supply amount. And/or, the second raw material is supplied with a third supply amount in the first process, while and the second raw material is supplied with a fourth supply amount larger than the third supply amount. Then, the ratio of oxygen to metal in the second portion 202 or 302 formed in the second process is lower than that in the first portion 201 or 301 formed in the first process.

Alternatively, a number of processes of supplying the first raw material containing the oxygen and/or a number of processes of supplying the second raw material containing the metal may be varied. That is, a number of the processes of supplying the first raw material is a first number in the first process, and a number of the processes of supplying the first raw material is a second number smaller than the first number in the second process. And/or, a number of the processes of supplying the second raw material is a third number in the first process, and a number of the processes of supplying the second raw material is a fourth number larger than the third number in the second process. Then, the ratio of oxygen to metal in the second portion 202 or 302 formed in the second process is lower than that in the first portion 201 or 301 formed in the first process.

Alternatively, a purge time (each purge time or a total purge time) of the first raw material containing the oxygen and/or a purge time (each purge time or a total purge time) of the second raw material containing the metal may be varied. That is, the first raw material is purged for a first process time in the first process, while and the first raw material is purged for a second process time longer than the first process time. And/or, the second raw material is purged for a third process time in the first process, while and the second raw material is purged for a fourth process time shorter than the third process time. Then, the ratio of oxygen to metal in the second portion 202 or 302 formed in the second process is lower than that in the first portion 201 or 301 formed in the first process.

Alternatively, a number of processes of purging the first raw material containing the oxygen and/or a number of processes of purging the second raw material containing the metal may be varied. That is, a number of the processes of purging the first raw material is a first number in the first process, and a number of the processes of purging the first raw material is a second number larger than the first number in the second process. And/or, a number of the processes of purging the second raw material is a third number in the first process, and a number of the processes of purging the second raw material is a fourth number smaller than the third number in the second process. Then, the ratio of oxygen to metal in the second portion 202 or 302 formed in the second process is lower than that in the first portion 201 or 301 formed in the first process.

By changing the process conditions gradually or stepwise from the first portion 201 or 301 to the second portion 202 or 302, the conductive region 20 of 30 having any of various ratios of oxygen to metal, as shown in (a) to (e) of FIG. 9, can be formed. One of the various process described above may be used or a plurality of process conditions may be used in combination.

Although the atomic layer deposition method is exemplified in the above as an example, the embodiments of the invention are not limited thereto. In other methods, a supply time (or a process time), a supply amount, a concentration, a number of processes, and the like of at least one of the first raw material containing the oxygen and the second raw material containing the metal may be varied. For example, the supply time, the supply amount, the concentration, the number of processes, and the like of the first raw material may be less in the second process than the first process, and/or the supply time, the supply amount, the concentration, and the number of processes, and the like may be greater in the second process than the first process.

According to this embodiment, the conductive regions 20 and 30 of the binary metal oxide layer having the amorphous structure can be formed by a simple process. At this time, the first portions 201 and 301 and the second portions 202 and 302 having different compositions of the conductive regions 20 and 30 can be formed by changing the process conditions. Thus, the solar cell 100 having excellent characteristics and efficiency can be formed by a simple process.

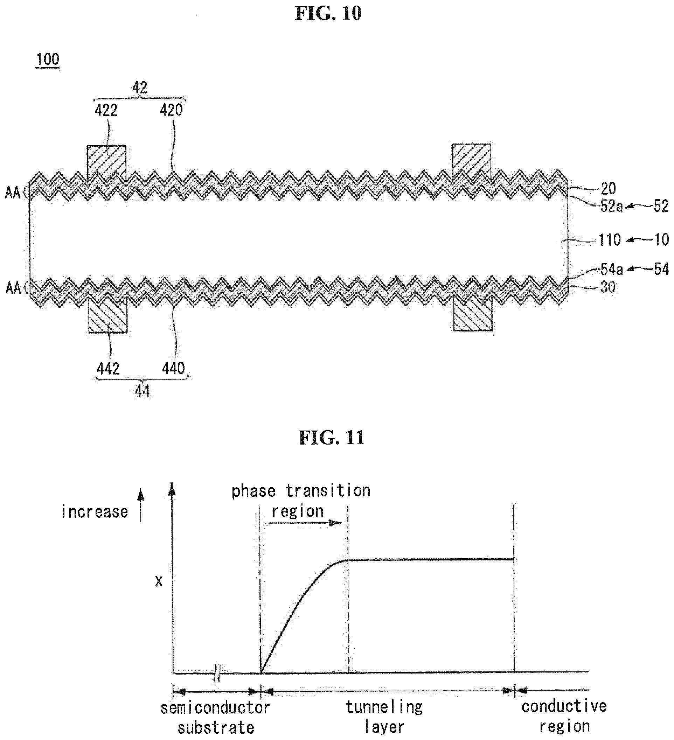

FIG. 10 is a cross-sectional view of a solar cell according to yet another embodiment of the invention.

Referring to FIG. 10, in the embodiment, a first tunneling layer 52 includes a first tunneling portion 52a formed of an oxide layer. For example, in the embodiment, the first tunneling layer 52 may be only formed of the first tunneling portion 52a and the first tunneling portion 52a may be in contact with the semiconductor substrate 10 and the first conductive region 20. More specifically, the first tunneling portion 52a may be a silicon oxide layer including a semiconductor (e.g., silicon) that constitutes the semiconductor substrate 10. In the embodiment, the first tunneling portion 52a may be formed at a low temperature using ozone. In this instance, the ozone penetrates into an inside of the semiconductor substrate 10 and is oxidized to form the first tunneling portion 52a. The process of forming the first tunneling portion 52a or the first tunneling layer 52 using the ozone will be described later in detail in a method for manufacturing a solar cell 100.

The first tunneling portion 52a formed by the oxidation in a state where the ozone penetrates into the semiconductor substrate 10 has a phase transition region having a thickness of 0.5mm or less at a portion adjacent to the semiconductor substrate 10. Accordingly, the first tunneling portion 52a may have an oxygen-rich structure. In one example, the first tunneling portion 52a has chemical formula SiOx, where x may be 1.6 to 2.2.

Here, the phase transition region may be defined by any of various methods. For example, as shown in FIG. 11, in a graph in which contents of silicon and oxygen are measured in a thickness direction of the first tunneling portion 52a, a thickness between a surface of the semiconductor substrate 10 and a portion where the contents of the silicon and the oxygen are uniform (that is, a portion where the value x of chemical formula SiOx is in 1.6 to 2.2 and the variation is 0.2 or less, for example, 0.1 or less) is defined as a thickness of the phase transition region. The value x in chemical formula SiOx may be measured or determined by X-ray photoelectron spectroscopy (XPS) or the like. Alternatively, a discontinuous portion of a silicon-oxygen lattice may be defined as the phase transition region in an image taken by a high resolution transmission electron microscope (HRTEM). In addition, the value x of chemical formula SiOx may be indirectly determined by measuring a band gap by an ellipsometer analysis or the like. For example, in the ellipsometer analysis, the band gap is decreased in an instance of a silicon-rich structure, and the band gap is increased in an instance of an oxygen-rich structure.

If the phase transition region is not formed or the phase transition region has a small thickness as described above, the first tunneling portion 52a may have low defect density, be chemically stable, and have excellent passivation properties. In the embodiment, the first tunneling portion 52a may include hydrogen. This can be easily accomplished by supplying hydrogen-including materials together with ozone during the ozone treatment process using the ozone. According to this, the passivation properties of the first tunneling portion 52a can be improved by the hydrogen.

Particularly, in the embodiment including the first conductive region 20 formed of the binary metal oxide layer, a defect density, passivation properties, etc. of the first tunneling portion 52a or the first tunneling layer 52 may largely affect efficiency of extracting a carrier or a lifetime of the carrier. Accordingly, in the solar cell 100 according to the embodiment, the efficiency of the solar cell 100 can be improved by improving the properties of the first tunneling portion 52a or the first tunneling layer 52.

On the other hand, if the oxide layer is formed by vapor deposition or the like, unlike in the embedment of the invention, the oxide layer may have a oxygen-deficient structure (for example, the value x of chemical formula is less than 1.6) or a thickness of the phase transition region may exceed 0.5 nm. This will be explained in more detail.

In the conventional art, an oxide layer is formed by a deposition method through supplying a raw material gas containing oxygen for a short time at 700 °C or higher (e.g., about 900 °C) and is used as a tunneling layer. Since the oxide layer must be thin to function as a tunneling layer, the deposition process is performed for a short time (e.g., several seconds or tens of seconds). Accordingly, it is difficult for oxygen to sufficiently diffuse into the semiconductor substrate 10, and there is a limit to increase of a reactivity of the reaction. Accordingly, oxygen becomes insufficient for forming an oxygen-silicon-oxygen (O-Si-O) bond in an initial stage of the deposition, and thus, the oxide layer has an oxygen-deficient structure or a portion of the oxide layer adjacent to the semiconductor substrate 10 (e.g., a phase transition region) in which oxygen is deficient is thick. As a result, the oxide layer has a silicon-rich structure, which may be detrimental to passivation properties. Also, since the hydrogen located on the surface of the semiconductor substrate 10 is removed by a high process temperature during the deposition process, the oxide layer may not have hydrogen, which may be more disadvantageous for the passivation properties.

In this instance, if oxygen deficiency in the oxide layer formed by the deposition is severe (i.e., the value x of chemical formula is very small), by a reaction between the oxide layer and the binary metal oxide of the first conductive region 20 formed thereon, an additional oxidation reaction may occur at an interface therebeteween. Then, the properties of the first conductive region 20 may be changed. Also, in order to improve the passivation property, a subsequent heat-treatment process for supplying hydrogen must be performed. Since the process for supplying the hydrogen should be performed in a separate process, the process becomes complicated and the properties of the first conductive region 20 having a low thermal stability may be undesirably changed in the subsequent heat-treatment process.

In the embodiment, since the first tunneling portion 52a is formed by the ozone treatment, it is possible to prevent the problems of the conventional art.

The descriptions of the thickness of the first tunneling layer 52 and the descriptions of the band diagram referring to FIG. 3 in the above-described embodiments and the above modified embodiments may be applied to the first tunneling portion 52a as they are.

A second tunneling layer 54 is formed of only a first tunneling portion 54a so that the first tunneling portion 54a may be in contact with each of the semiconductor substrate 10 and the second conductive region 30.

Except that the second tunneling layer 54 or the first tunneling portion 54a, the second conductive region 30, and the second electrode 44 are located on the back surface of the semiconductor substrate 10, they are the same as the first tunneling layer 52 or the first tunneling portion 52a, the first conductive region 20, and the first electrode 42, respectively. Thus, the descriptions of the first tunneling layer 52 or the first tunneling portion 52a, the first conductive region 20, and the first electrode 42 may be applied to the second tunneling layer 54 or the first tunneling portion 54a, the second conductive region 30, and the second electrode 44, respectively. However, the first conductive region 20 and the second conductive region 30 have different materials because the polarities of carriers extracted by the first conductive region 20 and the second conductive region 30 are different from each other. The first tunneling layer 52 and the second tunneling layer 54, and/or the first tunneling portion 52a and the second tunneling portion 54a may have the same thickness, shape, material and the like, or different thicknesses, shapes, materials, and the like.

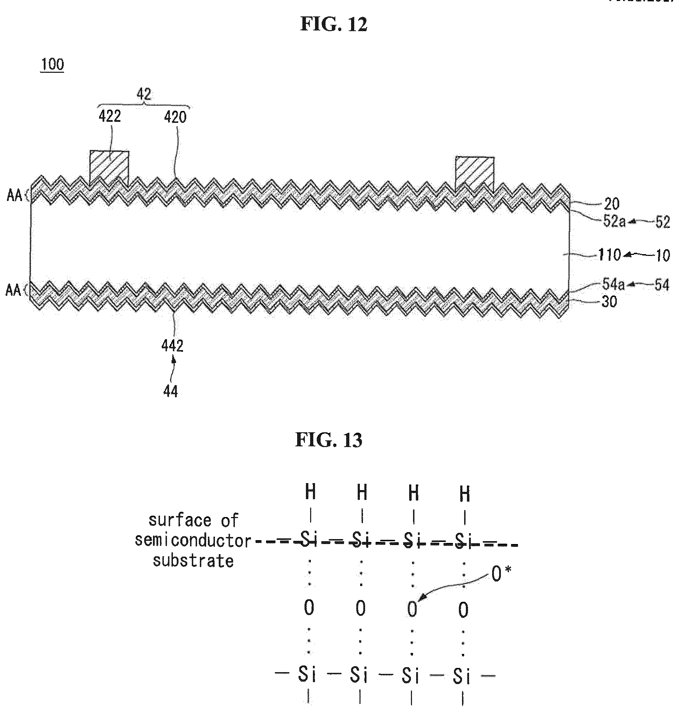

In the embodiment, the solar cell 100 has a bi-facial structure. However, the embodiments of the invention are not limited thereto. As another modified embodiment, as shown in FIG. 12, a second metal electrode layer 442 may be formed entirely on a second conductive region 30 at the back surface of the semiconductor substrate 10. The second metal electrode layer 442 acts as a reflective layer to reflect light that has passed through the semiconductor substrate 10 and reaches the back surface of the semiconductor substrate 10. In this instance, since the second metal electrode layer 442 is formed in a sufficient area, a second transparent electrode layer 440 (refer to FIG. 1) may be not formed and the second metal electrode layer 442 is formed directly on the second conductive region 30 to be in contact with the second conductive region 30. Thus, the structure can be simplified. However, the embodiments of the invention are not limited thereto, and a second transparent electrode layer 420 may be provided between the second conductive region 30 and the second metal electrode layer 422. These modifications may be applied to this embodiment as well as to other embodiments and modifications thereof.

According to this embodiment, the first and/or second tunneling layer 52 and/or 54 (or the first tunneling portion 52a or 54a) is formed by the ozone treatment to have an oxygen-rich structure, to have the phrase transition region with a very thin thickness, or not to have the phase transition region. Thereby, the defect density of the first and/or second tunneling layer 52 and/or 54 (or the first tunneling portion 52a or 54a) is small, and the first and/or second tunneling layer 52 and/or 54 (or the first tunneling portion 52a or 54a) is chemically stable and is excellent in passivation properties. In this instance, if the first and/or second tunneling layer 52 and/or 54 (or the first tunneling portion 52a or 54a) include the hydrogen, the passivation properties can be greatly improved by hydrogen passivation. In particular, the efficiency of the solar cell 100 having the first and/or second conductive regions 20 and/or 30 formed of the binary metal oxide layer can be improved.

A method for manufacturing the solar cell 100 according to the embodiment will now be described.

In a process of forming tunneling layers 52 and 54 shown in FIG. 5A, first tunneling portions 52a and 54a are formed on a front surface and a back surface of a semiconductor substrate 10, respectively, to form first and second tunneling layers 52 and 54. For example, the first tunneling portion 52a located on the front surface of the semiconductor substrate 10 and the second tunneling portion 54a located on the back surface of the semiconductor substrate 10 may be simultaneously formed. This can simplify the manufacturing process. However, the embodiments of invention are not limited thereto, and the first tunneling portion 52a and the second tunneling portion 54a may be formed by different processes.

In this instance, the first tunneling portions 52a and 54a may be formed by a heat-treatment of the semiconductor substrate 10 while supplying ozone as at least a part of a source gas. For example, the process of forming the first tunneling portions 52a and 54a constituting the first tunneling layer 52 and 54, respectively, may be performed in a deposition apparatus for depositing the conductive regions 20 and 30. That is, the ozone is used as the raw material gas in the process of forming the first tunneling portions 52a and 54a, and a material capable of forming the binary metal oxide is used as the raw material gas in the process of forming the conductive regions 20 and 30. The first tunneling portions 52a and 54a (or the first tunneling layers 52 and 54) and the conductive regions 20 and 30 are formed in the same deposition apparatus by changing the raw material gas (i.e., gas atmosphere). That is, the first tunneling portions 52a and 54a (or the first tunneling layers 52 and 54) and the conductive regions 20 and 30 are formed by an in-situ process that is carried out continuously in the same deposition apparatus. As a result, the conductive regions 20 and 30 are formed in a state where the first tunneling portions 52a and 54a are not exposed to atmosphere or an outside. Therefore, thicknesses and properties of the tunneling layers 52 and 54 can be prevented from being changed. Alternatively, a separate device (for example, an ultraviolet irradiation device) or the like may be used to form the first tunneling layers 52 and 54, thereby simplifying the process.

A temperature in the deposition apparatus is controlled by heating or by cooling, but it takes a long time to stabilize the temperature. On the other hand, while the gas atmosphere can be easily controlled by changing a kind of gas supplied into a deposition apparatus.

For example, in the embodiment, the first tunneling portions 52a and 54a may be formed by an atomic layer deposition or a physical vapor deposition, which is the same method as that of the conductive regions 20 and 30. In particular, the first tunneling portions 52a and 54a may be formed by an atomic layer deposition process in a state ozone is supplied. More specifically, the ozone is supplied into the atomic layer deposition apparatus to chemically react with the semiconductor material of the semiconductor substrate 10 to form an oxide layer, and then the ozone is purged to form one atomic layer of the oxide layer. Processes of supplying and purging the ozone are repeatedly performed to form the first tunneling portions 52a and 54a of an oxide layer having a desired thickness. According to this, the first tunneling portions 52a and 54a having a desired thickness can be formed by controlling a thickness of the first tunneling portions 52a and 54a in units of atomic layers.

In this instance, a process temperature for forming the first tunneling portions 52a and 54a may be 400°C or less (for example, 250°C or less). This is to prevent a temperature change from occurring when the first tunneling portions 52a and 54a and the conductive regions 20 and 30 are continuously formed by the in-situ process. On the other hand, if a temperature difference between the process temperature of the first tunneling portions 52a and 54a and the process temperature of the conductive regions 20 and 30 is large, it takes a long time to control the temperature, or the properties of the first tunneling portions 52a and 54a and the conductive regions 20 and 30 may be changed. Also, when the first tunneling portions 52a and 54a are formed at a low temperature, a surface or a terminal of the semiconductor substrate 10 may be maintained in a H-terminated state. For example, the temperature difference between the first tunneling portions 52a and 54a and the conductive regions 20 and 30 may be 100 °C or less, thereby further simplifying the process.

When the first tunneling portions 52a and 54a are formed at a relatively low temperature, as stated in the above, if the raw material gas including oxygen (or oxygen molecule) (O₂) is used, an oxidation may not sufficiently occur. Therefore, in the embodiment, ozone which forms an oxygen radical (O * radical) in the process of stabilizing the oxygen state due to its low chemical stability compared with oxygen is used. The oxygen radicals generated by the ozone have a very high oxidizing power and can react with the surface of the semiconductor substrate 10 to form the first tunneling portions 52a and 54a formed of a semiconductor oxide layer (for example, a silicon oxide layer). Furthermore, the oxygen radical can react with the semiconductor substrate 10 in a state of reaching to an inside of the semiconductor substrate 10 by a very fast diffusion rate and a small atomic radius. This will be described in detail with reference to FIG. 13.

FIG. 13 is a diagram showing a reaction by an ozone treatment process during the formation of the first tunneling portion in the method for manufacturing the solar cell 100 shown in FIG. 10.

Referring to FIG. 13, oxygen radicals supplied in the ozone treatment process penetrate into the inside of the semiconductor substrate 10 by a very fast diffusion rate and a small atomic radius. Thus, the oxygen radicals forms a silicon oxide by bonding a back bone of silicon-silicon bond positioned at the inside (i.e., a bulk) of the semiconductor substrate 10, not the terminal of the semiconductor substrate 10. Thus, the silicon oxide layer is formed in the state that the hydrogen is maintained at the terminal of the semiconductor substrate 10 as it is, and the hydrogen passivation effect can be maintained.

Thus, the first tunneling portions 52a and 54a may have the oxygen-rich structure, or may have the phase transition region with a very thin thickness (0.5 nm or less), or may not have the phase transition region. As a result, the first tunneling portions 52a and 54a having a small defect density and excellent passivation properties can be formed.

During the forming of the first tunneling portions 52a and 54a using the ozone heat-treatment process, the ozone gas may be supplied alone, and other gases may be supplied together with the ozone gas. Other gases may be supplied together with the ozone gas and be purged together with the ozone gas, or other gases may be supplied and purged after the ozone gas has been supplied and purged. Other materials may include a semiconductor-including material (e.g., a silicon-including material, such as silane) that includes a semiconductor (e.g., silicon) that constitutes a portion of the first tunneling portions 52a and 54a. Alternatively, a hydrogen-including material may be used as the other gas. Then, the first tunneling portions 52a and 54a may include hydrogen, thereby enabling hydrogen passivation without performing a separate hydrogen passivation process. As the hydrogen-including material, water (H₂O) or hydrogen gas (H₂) may be used. The water may be supplied in a liquid state, which may actually react in a vaporized state.

In the above descriptions, the first tunneling portions 52a and 54a can be formed in the ozone heat-treatment process using the ozone to simplify the process by the in-situ process of the first tunneling portions 52a and 54a and the conductive regions 20 and 30. However, the embodiments of the invention are not limited thereto. Therefore, the first tunneling portions 52a and 54a may be formed by an atomic layer deposition using a silicon precursor and oxygen. In this instance, the first tunneling portions 52a and 54a and the conductive regions 20 and 30 may be formed by an in-situ process. Various other processes may be used.

For example, a process temperature of the atomic layer deposition process may be 400 °C or less (for example, 250 °C or less). Also, the process temperature of the atomic layer deposition process may be 100 °C or more (e.g., 150 °C or more). Alternatively, a process temperature of the physical vapor deposition process may be from a room temperature to 400 °C (for example, 250 °C or less) (for example, 5 to 250 °C, for example, 5 to 150 °C).

Next, as shown in FIG. 5B, the conductive regions 20 and 30 are formed in the forming of the conductive regions 20 and 30, respectively. In the embodiment, the conductive regions 20 and 30 may be performed by a continuous process in an apparatus in which the tunneling layers 52 and 54 are formed. The forming process of the conductive regions 20 and 30 has been described above with reference to FIG. 5B, and thus the detailed descriptions thereof will be omitted.

For example, in the embodiment, a thicknesses of the conductive regions 20 and 30 may be 2 nm or more (for example, 5 nm or more). Since the conductive regions 20 and 30 having uniform thicknesses can be formed by the first tunneling portions 52a and 54a in the embodiment, wanted effects can be achieved even when the thicknesses of the conductive regions 20 and 30 may be 2 nm or more.

Accordingly, as shown in FIG. 5C, a process of forming first and/or second electrode 42 and/or 44 may be performed at a temperature of 400 °C or less (e.g., 350 °C or less, for example, 300 °C or less, for example, 250 °C or less). Also, all of processes performed after forming of the conductive regions 20 and 30 are performed at a process temperature of 400 °C or less (e.g., 350 °C or less, for example, 300 °C or less, for example, 250 °C or less). Thus, in a manufacturing process of the solar cell 100, there is no process to be performed at a temperature exceeding 400 °C, and all processes (that is, the process of forming the first tunneling portions 52a and 54a or the tunneling layers 52 and 54, the process of forming the conductive regions 20 and 30, and forming the electrodes 42 and 44) can be performed at a temperature of 400°C or less as a whole. Due to this temperature, an amorphous structure or an amorphous portion AA of the conductive regions 20 and 30 can be maintained in a final structure of the solar cell 100 without being crystallized.

According to the embodiment, at least a portion of the tunneling layer 52 or 54 (i.e., at least a portion of the tunneling layer 52 or 54 that is adjacent to or in contact with the conductive region 20 or 30) may be formed by an in-situ process with the conductive region 20 or 30, and thus, the process can be simplified more. In this instance, according to the ozone treatment, at least a part of the tunneling layers 52 and 54 can be formed in the same method as the conduction type regions 20 and 30 even at a low temperature, and thus, the in-situ process can be easily applied to the forming of the tunneling layer 52 or 54 and the conductive region 20 or 30. Thus, the solar cell 100 having excellent characteristics and efficiency can be formed by a simple process.

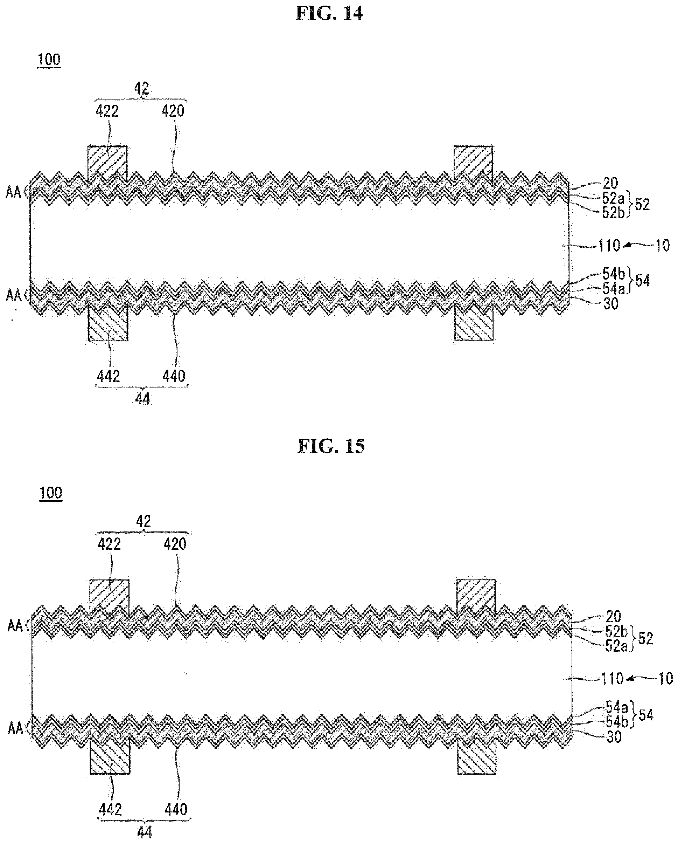

FIG. 14 is a cross-sectional view of a solar cell according to yet still another embodiment of the invention.

Referring to FIG. 14, in the embodiment, a first tunneling layer 52 may further include a second tunneling portion 52b in addition to a first tunneling portion 52a. In one example, the second tunneling portion 52b is formed adjacent (e.g., in contact) with a semiconductor substrate 10, and the first tunneling portion 52a is positioned between the second tunneling portion 52b and a first conductive region 20 entirely at a front surface of the semiconductor substrate 10. In this instance, the second tunneling portion 52b may be an undoped layer containing no dopant.

The second tunneling portion 52b may include any of various materials through which majority carriers can be tunneled. For example, the second tunneling portion 52b may include any of an oxide, a nitride, a semiconductor, a conductive polymer, and the like. For example, the second tunneling portion 52b may include any of silicon oxide, silicon nitride, silicon oxynitride, silicon carbide, intrinsic amorphous semiconductor, intrinsic polycrystalline semiconductor, and the like.

In particular, the second tunneling portion 52b may be formed of a silicon oxide layer including silicon oxide. This is because the silicon oxide layer is a layer which is excellent in passivation properties and through which the carrier can be easily tunneled. Such a silicon oxide layer may be formed by a thermal oxidation or a chemical oxidation. Alternatively, the second tunneling portion 52b may be formed using an ozone treatment, but may be formed by an ozone treatment using a different process from a process of the first tunneling portion 52a. For example, in the different ozone treatment, the semiconductor substrate 10 may be dipped in a solution where the ozone gas is dissolved to form the second tunneling portion 52b. The solution may be water, nitric acid, sulfuric acid, hydrochloric acid, hydrogen peroxide, or mixtures thereof. In one example, a process temperature may be 80 to 120 °C, and a process time may be 1 minute to 1 hour (for example, 1 minute to 20 minutes). The process temperature and the process time are limited to a range suitable for forming the second tunneling portion 52b, but the embodiments of the invention are not limited thereto. As another example, ultraviolet rays (UVs) may be applied to oxygen-including air to convert oxygen in the air to ozone, and the ozone is used for forming the second tunneling portion 52b on the semiconductor substrate 10. In this instance, it is advantageous to apply ultraviolet rays to a portion adjacent to the semiconductor substrate 10, and the generation and the lifetime of the ozone may be influenced by a temperature, humidity, etc. of the air. In this instance, since the second tunneling portion 52b and the first tunneling portion 52a are formed of the same silicon oxide layer, they may be recognized as one layer differently from FIG. 14.

Alternatively, the second tunneling portion 52b may be made of an intrinsic amorphous silicon (i-a-Si) layer. Then, since the second tunneling portion 52b includes the same semiconductor material as the semiconductor substrate 10, the second tunneling portion 52b may have similar properties to the semiconductor substrate 10, and the second tunneling portion 52b may be easily hydrogenated. Thus, the passivation properties can be improved more effectively. However, the embodiments of the invention are not limited thereto. Accordingly, the second tunneling portion 52b may be formed of an intrinsic amorphous silicon carbide (i-a-SiCx) layer or an intrinsic amorphous silicon oxide (i-a-SiOx) layer. According to this, effect due to a wide energy band gap can be improved, but passivation properties may be somewhat lower than an instance including the intrinsic amorphous silicon (i-a-Si) layer.

A thickness of the second tunneling portion 52b may be equal to, less than, or greater than a thickness of the first conductive region 20 and/or the first tunneling portion 52a. Alternatively, the thickness of the second tunneling portion 52b may be 10 nm or less. For example, the second tunneling portion 52b may have a thickness of 5 nm or less (more specifically, 2 nm or less, for example, 0.5 nm to 2 nm) in order to sufficiently realize the tunneling effect. In particular, a sum of the thicknesses of the first tunneling portion 52a and the second tunneling portion 52b (i.e., a thickness of the first tunneling layer 52) may be 10 nm or less. However, the embodiments of the invention are not limited thereto, and the thickness of the first tunneling layer 52 or the second tunneling portion 52b may have any of various values.

The second tunneling portion 52b may be formed by any of a thermal growth, a deposition (e.g., a chemical vapor deposition (PECVD)), an atomic layer deposition (ALD)), a chemical oxidation, or the like. For example, the second tunneling portion 52b, the first tunneling portion 52a, and the first conductive region 20 may be formed by an in-situ process (e.g., a continuous process using an atomic layer deposition). Alternatively, the first tunneling portion 52a and the first conductive region 20 may be formed in an in-situ process, which is separated from a process of forming the second tunneling portion 52b. That is, the process forming the second tunneling portion 52b and the process of forming the first tunneling portion 52a and the first conductive region 20 may be not a continuous process. Various other variations are possible.

When the first tunneling layer 52 includes the first tunneling portion 52a and the second tunneling portion 52b which are stacked to each other, the first tunneling layer 52 may act as a capping layer or a barrier buffer layer for preventing a metal included in the first conductive region 20 from diffusing to the semiconductor substrate 10. As a result, the passivation properties can be maintained to be excellent, and the leakage current can be prevented and thus the electrical properties can be enhanced.

Also, a second tunneling layer 54 may further include a second tunneling portion 54b in addition to a first tunneling portion 54a. The descriptions of the second tunneling portion 52b of the first tunneling layer 52 may be applied to the second tunneling portion 54b of the second tunneling layer, except for a position and the like, and thus, the related descriptions of the second tunneling portion 54b will be omitted.

Although the first tunneling portion 52a or 54a is illustrated as being located between the second tunneling portion 52b or 54b and the semiconductor substrate 10, the embodiments of the invention are not limited thereto. As another example, the second tunneling portion 52b or 54b may be located between the first tunneling portion 52a or 54a and the semiconductor substrate 10, as shown in FIG. 15. In this instance, the second tunneling portion 52b or 54b may be formed after the first tunneling portion 52a or 54a is formed. For example, the first tunneling portion 52a or 54a, the second tunneling portion 52b or 54b, and the conductive region 20 or 30 may be formed by an in-situ process (e.g., a continuous process using atomic layer deposition).

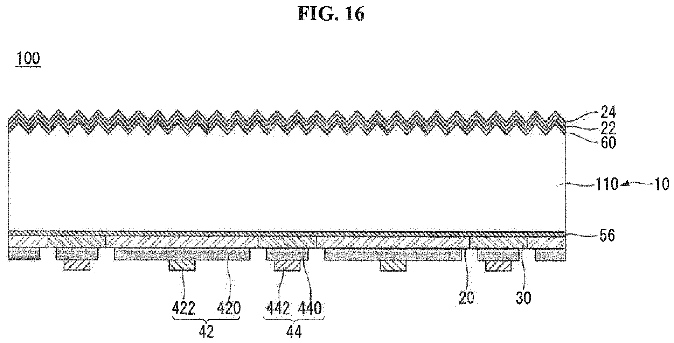

Also, it is exemplified in' FIGS. 14 and 15 that the solar cells 100 have the same structure as the solar cell 100 shown in FIG. 1, FIG. 6, or FIG. 10 except for the tunneling layers 52 and 54. However, the embodiments of the invention are not limited thereto. Therefore, in a solar cell 100 shown in FIG. 16 to be described later, a tunneling layer 56 may have a first tunneling portion, or may have a first tunneling portion and a second tunneling portion. The descriptions of the first tunneling portion 52a or 54a and/or the second tunneling portion 52b or 54b in the above may be applied to the tunneling layer 56 as they are, except for a position and the like for first and/or second tunneling portions.

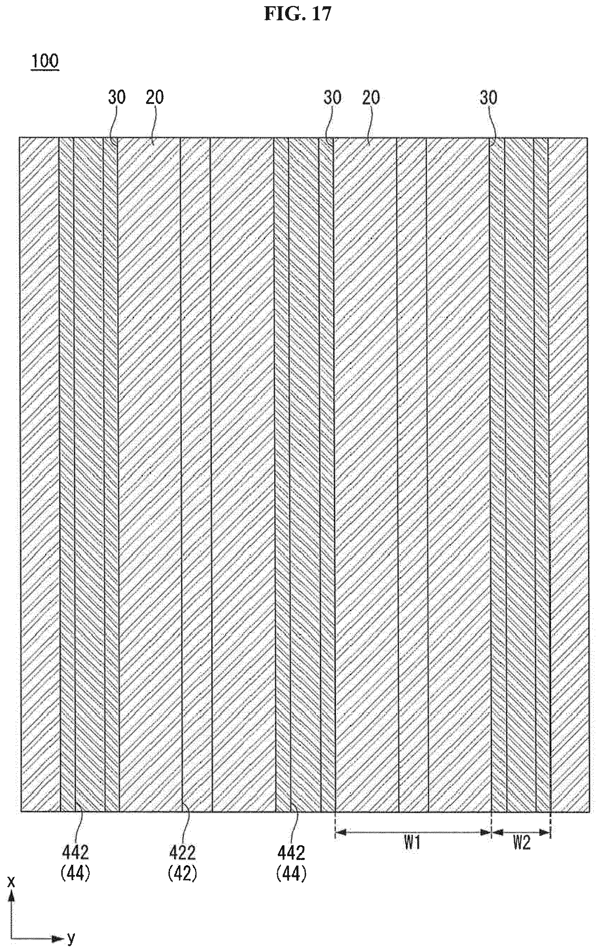

FIG. 16 is a cross-sectional view of a solar cell according to yet still further another embodiment of the invention, and FIG. 17 is a rear plan view of the solar cell shown in FIG.16. A first transparent electrode layer 420 of a first electrode 42 and a second transparent electrode layer 440 of a second electrode 44 are not shown in FIG. 17 for simplicity.

Referring to FIGS. 16 and 17, in the embodiment, a tunneling layer 56 may be disposed on a back surface of a semiconductor substrate 10, and first and second conductive regions 20 and 30 may be disposed on the tunneling layer 56 to be coplanar. A front-surface-field generating layer (or a front surface field region) 60 may be entirely disposed on a front surface of the semiconductor substrate 10, and a transparent conductive layer 22 and an anti-reflection layer 24 may be disposed on the semiconductor substrate 10 or the front-surface-field generating layer 60.

As for the tunneling layer 56, the descriptions of the first or second tunneling layer 52 or 54 of the above-described embodiment may be applied as they are. The descriptions of the first and second conductive regions 20 and 30 of the above-described embodiment may be applied to the first and second conductive regions 20 and 30, except for positions and shapes of the first and second conductive regions 20 and 30. The positions and the shapes of the first and second conductive regions 20 and 30 will be described later in more detail with reference to FIG. 17.

In this instance, an anti-reflection structure may be formed on the front surface of the semiconductor substrate 10, and a back surface of the semiconductor substrate 10 may be a mirror-polished surface. This is because properties of the back surface where the tunneling layer 56 is formed may greatly affect carrier mobility and the like.

In the embodiment, the first and second conductive regions 20 and 30 may be disposed on (for example, be in contact with) the tunneling layer 56, and side surfaces of the first and the second conductive regions 20 and 30 may be in contact with each other. Since the first conductive region 20 and the second conductive region 30 do not include a semiconductor material and a dopant, there is no problem such as a short circuit even if the side surfaces of the first and the second conductive regions 20 and 30 are in contact with each other. However, the embodiments of the invention are not limited thereto. Thus, as a modified embodiment, a barrier region may be located between the first and second conductive regions 20 and 30 on the tunneling layer 20 to prevent them from being in contact with each other. The barrier region may be formed of an empty space, or may be formed of an intrinsic semiconductor layer, a compound such as an oxide, or the like.

The front-surface-field generating layer 60 disposed on (for example, in contact with) the front surface of the semiconductor substrate 10 may be a layer having a fixed charge or a binary metal oxide layer capable of selectively collecting electrons or holes as described above. For example, the front-surface-field generating layer 60 may be an aluminum oxide layer comprising an aluminum oxide with a fixed charge. Alternatively, the front-surface-field generating layer 60 may include a molybdenum oxide layer, a tungsten oxide layer, a vanadium oxide layer, a nickel oxide layer, a rhenium oxide layer, a titanium oxide layer, a zinc oxide layer, a niobium oxide layer, or the like. Alternatively, the front-surface-field generating layer 60 may be a layer including a plurality of the above-described layers. The front-surface-field generating layer 60 may be formed of an oxide layer to effectively passivate an entire surface of the semiconductor substrate 10.

In this instance, the front-surface-field generating layer 60 may be formed of the same layer as one of the metal compound layers constituting the first and second conductive regions 20 and 30, thereby simplifying the manufacturing process. For example, each of the front-surface-field generating layer 60 and the second conductive region 30 may be formed of a titanium oxide layer.

The front-surface-field generating layer 60 may exhibit the effect of a field region for preventing a recombination in a vicinity of the front surface of the semiconductor substrate 10 by selectively collecting electrons or holes, or by having fixed charges in a state where it is not connected to electrodes 42 and 44 that are connected to other solar cell 100 or an external circuit. In this instance, the semiconductor substrate 10 does not have a separate doped region and consists only of a base region 110 so that defects of the semiconductor substrate 10 can be minimized.

In this instance, a thickness of the front-surface-field generating layer 60 may be the same as or less than a thickness of the first or second conductive region 20 or 30. Because the front-surface-field generating layer 60 is not a layer for transferring a carrier to the outside, it may have a relatively small thickness. For example, the thickness of the front-surface-field generating layer 60 may be 1 nm to 10 nm. Within the thickness range, the effect of the front-surface-field generating layer 60 can be sufficiently realized. However, the embodiments of the invention are not limited to the thickness of the front-surface-field generating layer 60.

In the drawings, another intermediate layer may be located between the semiconductor substrate 10 and the front-surface-field generating layer 60. Descriptions of the tunneling layer 56 or the first or second tunneling layer 52 or 54 of the above-described embodiment may be applied to the intermediate layer. In this instance, the tunneling layer 56 located on the back surface of the semiconductor substrate 10 and the intermediate layer located on the front surface of the semiconductor substrate 10 may include the same material or different materials. For example, the tunneling layer 56 located on the back surface of the semiconductor substrate 10 and the intermediate layer located on the front surface of the semiconductor substrate 10 may be formed together by the same process.

The transparent conductive layer 22 may be positioned on (e.g., be in contact with) the front surface of the semiconductor substrate 10 or the front-surface-field generating layer 60. The transparent conductive layer 22 is a floating electrode that is not connected to an external circuit or other solar cell 100. The floating electrode can prevent unnecessary ions and the like from gathering on the surface of the semiconductor substrate 10. Accordingly, it is possible to prevent a deterioration phenomenon (for example, a potential induced degradation (PID)) of a solar cell module in a high temperature and high humidity environment. The transparent conductive layer 22 is not essential, and thus, the transparent conductive layer 22 need not be provided.

For example, the transparent conductive layer 22 may include indium tin oxide (ITO), carbon nano tube (CNT), or the like. However, the embodiments of the invention are not limited thereto, and the transparent conductive layer 22 may include any of other various materials.

The anti-reflection layer 24 may be positioned on (e.g., be in contact with) the front surface of the semiconductor substrate 10 or the transparent conductive layer 22. The anti-reflection layer 24 reduces reflectance of light incident on the front surface of the semiconductor substrate 10. Thus, the amount of light reaching the solar cell 100 can be increased. Accordingly, short-circuit current of the solar cell 100 can be increased.

The anti-reflection layer 24 may be formed of any of various materials. For example, the anti-reflection layer 24 may be a single layer selected from the group consisting of a silicon nitride layer, a silicon nitride layer having hydrogen, a silicon oxide layer, a silicon oxynitride layer, an aluminum oxide layer, a silicon carbide layer, MgF₂, ZnS, TiO₂ and CeO₂, and may have a multi-layered structure in which two or more layers of the above are combined. As one example, the anti-reflection layer 24 may be a silicon nitride layer.

The front-surface-field generating layer 60, the transparent conductive layer 22, and the anti-reflection layer 24 may be formed entirely on the front surface of the semiconductor substrate 10. Thus, the manufacturing process can be simplified and the effect of each layer can be sufficiently achieved.

In another modified embodiment, a doped region formed by doping a dopant having a conductive type the same as the base region 110 to the front surface of the semiconductor substrate 10 at a high concentration may be used as a front surface field region, without the front-surface-field generating region. In this instance, a passivation layer and/or the anti-reflection layer 24 formed of an insulating material may be disposed on the doped region.

Referring to FIG. 17, in the embodiment, the first conductive regions 20 and the second conductive regions 30 are alternately arranged in a direction crossing a longitudinal direction of the first or second conductive region 20 or 30, and each of the first conductive regions 20 and the second conductive regions 30 may have a stripe shape. In the drawing, a plurality of first conductive regions 20 spaced apart from each other may be connected to each other at one edge, and a plurality of second conductive regions 30 spaced from each other may be connected to each other at the other edge. However, the embodiments of the invention are not limited thereto.

In this instance, an area of the first conductive regions 20 for collecting carriers (i.e., holes) different from the majority carriers of the base region 110 may be greater than an area of the second conductive regions 30 for collecting carriers (i.e. electrons) the same as the majority carriers of the base region 110. Thus, the first conductive region 20 acting as the emitter region can be formed in a sufficient area. By the first conductive region 20 with a large area, holes having a relatively slow moving speed can be effectively collected. As one example, the areas of the first conductive regions 20 and the second conductive regions 30 may be adjusted by varying their widths. That is, a width W1 of the first conductive region 20 may be larger than a width W2 of the second conductive region 30.

First metal electrode layers 422 of the first electrode 42 may have a stripe shape corresponding to the first conductive regions 20 and second metal electrode layers 442 of the second electrode 44 may have a stripe shape corresponding to the second conductive regions 30. The first transparent electrode layers 420 of the first electrode 42 may have a stripe shape, each having a larger area than that of the first metal electrode layer 422, and the second transparent electrode layer 420 of the second electrode 44 may have a stripe shape, each having a larger area than that of the second metal electrode layer 442. The first electrodes 42 may be connected to each other at one edge, and the second electrodes 44 may be connected to each other at the other edge. However, the embodiments of the invention are not limited thereto.

In the embodiment, the first transparent electrode layer 420 and the second transparent electrode layer 440 are not essential and the first transparent electrode layer 420 and the second transparent electrode layer 440 need not be formed. In this instance, the first metal electrode layer 422 and the second metal electrode layer 442 may be in contact with the first and second conductive regions 20 and 30, respectively. In this instance, the structure can be simplified.

In the solar cell 100 according to the embodiment, the first and second electrodes 42 and 44 (particularly, the first and second metal electrode layers 422 and 442) are all positioned on the back surface of the semiconductor substrate 10 so that there is no part for blocking the light at the front surface of the semiconductor substrate 10, thereby minimizing the light loss. Particularly, in the embodiment, at least one of the first and second conductive regions 20 and 30 is formed of a metal compound layer, and thus, the first and second metal electrode layers 422 and 442 of the first electrode 42 and the second electrode 44 may be widely formed. In this instance, by using the back-contact structure, the problem caused by the shading loss can be prevented.

The solar cell 100 may be formed by forming the tunneling layer 56 on the back surface of the semiconductor substrate 10 as stated in the descriptions with reference to FIG. 5A, forming the first and second conductive regions 20 and 30 thereon as stated in the descriptions with reference to FIG. 5B, and forming the first and second electrodes 42 and 44 formed thereon as stated in the descriptions with reference to FIG. 5C. In order to form the first and second conductive regions 20 and 30, the first and second transparent electrode layers 420 and 440, and/or the first and second metal electrode layers 422 and 442 having predetermined patterns, a mask or a mask layer may be used.

Hereinafter, the invention will be described in more detail with reference to experimental examples of the invention. However, experimental examples of the invention are provided only for exemplifying the invention and the embodiments of the invention are not limited thereto.

### Embodiment 1

First and second tunneling layers formed of amorphous silicon were formed on front and back surfaces of an n-type single-crystalline silicon substrate. A first conductive region formed of a molybdenum oxide layer and a second conductive region formed of a titanium oxide layer were formed. The first conductive region was formed by an atomic layer deposition process at a process temperature of 200°C and had a thickness of 10 nm, and the second conductive region was formed by an atomic layer deposition process at a process temperature of 200°C and had a thickness of 10 nm. Then, a transparent electrode layer and a metal electrode layer were sequentially formed to form first and second electrodes.

### Embodiment 2

A solar cell was manufactured in the same method as in Embodiment 1 except that a thickness of a first conductive region was 20 nm and a thickness of a second conductive region was 20 nm.

### Embodiment 3

A solar cell was manufactured in the same method as in Embodiment 1, except that a thickness of a first conductive region was 30 nm and a thickness of a second conductive region was 30 nm.

### Embodiment 4

A solar cell was manufactured in the same method as in Embodiment 1 except that a thickness of a first conductive region was 6 nm and a thickness of a second conductive region was 6 nm.

### Embodiment 5

A solar cell was manufactured in the same method as in Embodiment 1 except that a process temperature of an atomic layer deposition process for forming a first conductive region was 150 °C and a process temperature of an atomic layer deposition process for forming a second conductive region was 150 °C.

### Embodiment 6

A solar cell was manufactured in the same method as in Embodiment 1 except that a process temperature of an atomic layer deposition process for forming a first conductive region was 250 °C and a process temperature of an atomic layer deposition process for forming a second conductive region was 250 °C.

### Comparative Example 1

A solar cell was manufactured in the same method as in Embodiment 1 except that a first conductive region was formed by a chemical vapor deposition process and a second conductive region was formed by a chemical vapor deposition process.

### Comparative Example 2

A solar cell was manufactured in the same method as in Embodiment 1 except that a process temperature of an atomic layer deposition process for forming a first conductive region was 350 °C and a process temperature of an atomic layer deposition process for forming a second conductive region was 350 °C.

### Comparative Example 3

A solar cell was manufactured in the same method as in Embodiment 1 except that a process temperature of an atomic layer deposition process for forming a first conductive region was 80 °C and a process temperature of an atomic layer deposition process for forming a second conductive region was 80 °C.

### Comparative Example 4

A solar cell was manufactured in the same method as in Embodiment 1 except that a thickness of a first conductive region was 40 nm and a thickness of a second conductive region was 40 nm.

### Comparative Example 5

A solar cell was manufactured in the same method as in Embodiment 1 except that a thickness of a first conductive region was 3 nm and a thickness of a second conductive region was 3 nm.

First area ratios and second area ratios of the solar cells according to Embodiments 1 to 4 were determined and are shown in Table 1. The first area ratio is a ratio of an area of an amorphous portion at an interfacial portion of the first conductive region, and the second area ratio is a ratio of an area of an amorphous portion at an interfacial portion of the second conductive region. Hereinafter, the first or second area ratio of the amorphous portion was determined by using a transmission electron microscope (TEM) photograph. A high-resolution transmission electron microscope is suitable for discriminating an amorphous structure from a crystalline structure because even the lattice can be confirmed. In addition, the first or second area ratio of the amorphous portion can be confirmed by X-ray rotational analysis (XRD).

**[Table 1]**

| | First Area Ratio [%] | Second Area Ratio [%] |
|---|---|---|
| Embodiment 1 | 99.5 | 99.5 |
| Embodiment 2 | 99 | 99 |
| Embodiment 3 | 99 | 99 |
| Embodiment 4 | 99 | 99 |

Referring to Table 1, it can be seen that the solar cells according to Embodiments 1 to 4 have an amorphous structure with a high area ratio (for example, 95% or more) at the interfacial portion. It is expected that the amorphous structure can be formed with a high area ratio at the interfacial portion due to a specific process, a temperature of forming the first and second conductive region, and thicknesses of the first and second conductive regions.

The first area ratios and the second area ratios of the solar cells according to Embodiment 1 and Comparative Example 1 were determined and are shown in Table 2.

**[Table 2]**

| | First Area Ratio [%] | Second Area Ratio [%] |
|---|---|---|
| Embodiment 1 | 99.5 | 99.5 |
| Comparative Example 1 | 60 | 60 |

Referring to Table 2, it can be seen that the amorphous structure is formed with a high area ratio (for example, 95% or more) at the interfacial portion in Embodiment 1, whereas the amorphous structure is formed with a low area ratio at the interfacial portion in Comparative Example 1. According to this, it is difficult to form an amorphous structure with a high area ratio at the interfacial portion by the chemical vapor deposition process.

Accordingly, it can be seen that the amorphous structure can be maintained with a high area ratio at the interfacial portion of the first and second conductive regions by using a specific process from Embodiments 1, 5 and 6.

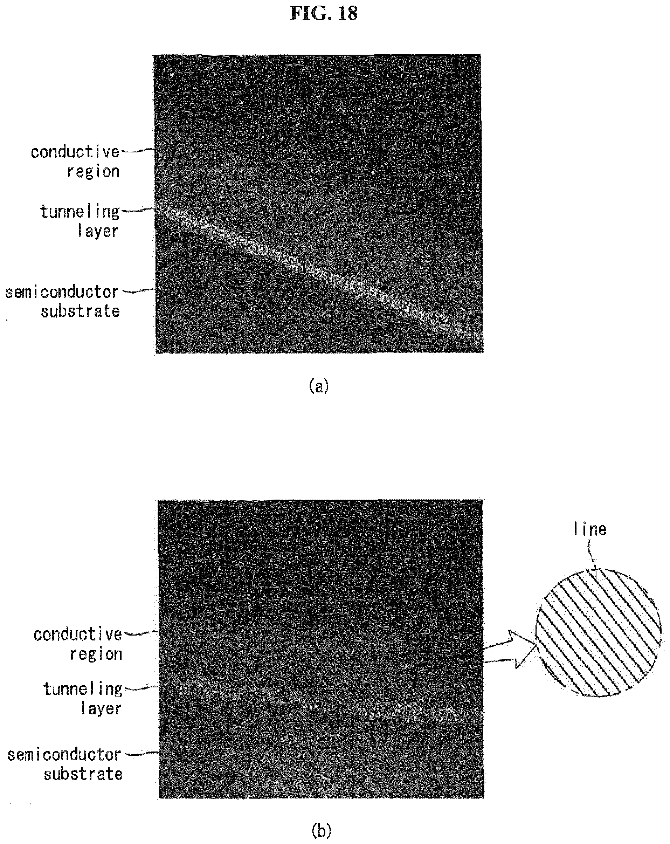

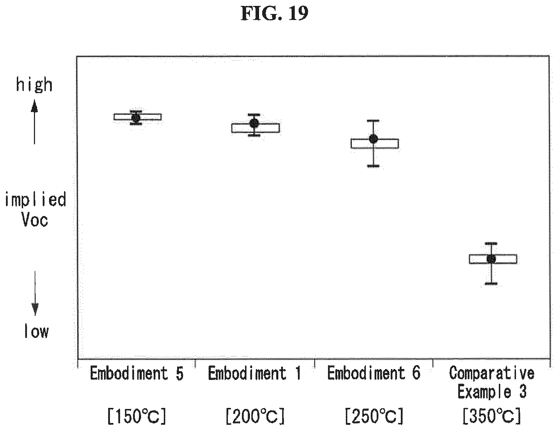

The first area ratios and the second area ratios of the solar cells according to Embodiment 1 and Comparative Example 2 were determined and are shown in Table 3, and transmission electron microscope photographs of the solar cells according to Embodiment 1 and Comparative Example 2 are shown in (a) and (b) of FIG. 18, respectively. Also, implied open-circuit voltages (implied Vocs) of the solar cells according to Embodiments 1, 5 and 6 and Comparative Example 3 were measured and are shown in FIG. 19.

**[Table 3]**

| | First Area Ratio [%] | Second Area Ratio [%] |
|---|---|---|
| Embodiment 1 | 99.5 | 99.5 |
| Comparative Example 2 | 90 | 90 |

Referring to Table 3, it can be seen that an amorphous structure is formed with a high area ratio (for example, 95% or more) at an interfacial portion in Embodiment 1, whereas an amorphous structure is formed with a relatively low area ratio at an interfacial portion in Comparative Example 1. According to this, when the process temperature exceeds a certain temperature (for example, above 250°C), it is difficult to form an amorphous structure with a high area ratio at the interfacial portion.

A pattern due to a crystal structure is not seen in a conductive type region in the solar cell according to Embodiment 1 with reference to (a) of FIG. 18, whereas a predetermined pattern (line) is seen in the solar cell according to Comparative Example 2 with reference to (b) of FIG. 18 because the conductivity type region has a crystalline structure. Also, with Reference to FIG. 19, it can be seen that the implied open-circuit voltages of the solar cells according to Embodiments 1, 5, and 6 having a process temperature of 250 °C or less are excellent, while the implied open-circuit voltage of the solar cell according to Comparative Example 2 having a process temperature of 350°C is very low. It is expected that this is because the amorphous structure may not be formed with a high area ratio at the interfacial portion of the first and/or the second conductive regions in the solar cell according to Comparative Example 2.

Thus, in the solar cells according to Embodiments 1, 5, and 6, the amorphous structure can be maintained with a high area ratio at the interfacial portion of the first and second conductive regions by maintaining the process temperature at a constant level, and thus, the implied open-circuit voltages are very high.

First porosities and second porosities of the solar cells according to Embodiment 1 and Comparative Example 3 were determined and are shown in Table 4. The first porosity is a porosity of the first conductive region, and the second porosity is a porosity of the second conductive region.

**[Table 4]**

| | First Porosity | Second Porosity |
|---|---|---|
| Embodiment 1 | Low | Low |
| Comparative Example 3 | High | High |

Referring to Table 4, the first and second porosities of the first and second conductive regions are low and thus the first and second conductive regions are suitable for extracting and collecting desired carriers in the solar cell according to Embodiment 1, whereas the first and second porosities of the first and second conductive regions are high and thus the first and second conductive regions are not suitable for extracting and collecting desired carrier in the solar cell according to Comparative Example 3.

As a result, it can be seen that the first and second conductive regions can be formed to have excellent properties at a process temperature higher than a certain temperature.

The first area ratios and second area ratios of the solar cells according to Embodiments 1 to 4, and Comparative Example 4 were determined and implied open-circuit voltages (implied Vocs) of the solar cells according to Embodiments 1 to 4, and Comparative Example 5 were determined, and are shown in Table 5.

**[Table 5]**

| | First Area Ratio [%] | Second Area Ratio [%] | Vimp |
|---|---|---|---|
| Embodiment 1 | 99.5 | 99.5 | 680 mV or more |
| Embodiment 2 | 99 | 99 | 680 mV or more |
| Embodiment 3 | 99 | 99 | 680 mV or more |
| Embodiment 4 | 99 | 99 | 680 mV or more |
| Comparative Example 4 | 90 | 90 | - |
| Comparative Example 5 | - | - | Less than 680 mV |

Referring to Table 5, in the solar cells according to Embodiments 1 to 4, in which the thicknesses of the first and second conductive regions are in the range of 5 nm to 30 nm, an amorphous structure is formed with a high area ratio (for example, 95% or more) at the interfacial portion. On the other hand, in the solar cell according to Comparative Example 4 in which the thicknesses of the first and second conductive regions are 40 nm, the area ratio of the amorphous structure at the interfacial portion is relatively low. If the thickness of the first and second conductive regions exceeds a certain level, it is difficult to maintain the amorphous structure with a high area ratio.

Also, it can be seen that the solar cell according to Comparative Example 5 having thicknesses of the first and second conductive regions of less than 5 nm has a low implied open-circuit voltage, as compared to the solar cells according to Embodiments 1 to 4 in which the thicknesses of the first and second conductive regions are in the range of 5 nm to 30 nm.

Thus, it can be seen that, in the solar cells according to Embodiments 1 to 4, the first and second conductive regions are formed to have thicknesses in a certain ranges, and thus, the amorphous structures can be maintained with a high area ratio at the interfacial portions of the first and second conductive regions. As a result, the solar cells according to Embodiments 1 to 4 can have enhanced efficiency.

The above described features, configurations, effects, and the like are included in at least one of the embodiments of the invention, and should not be limited to only one embodiment. In addition, the features, configurations, effects, and the like as illustrated in each embodiment may be implemented with regard to other embodiments as they are combined with one another or modified by those skilled in the art. Thus, content related to these combinations and modifications should be construed as including in the scope and spirit of the invention as disclosed in the accompanying claims.

## Claims

1. A method for manufacturing a solar cell, the method comprising:
forming a first tunneling layer on one surface of a semiconductor substrate;
forming a first conductive region on the first tunneling layer so that the first conductive region comprises a metal oxide layer having an amorphous structure; and
forming a first electrode electrically connected to the first conductive region.

2. The method according to claim 1, wherein at least an interfacial portion of the first conductive region adjacent to the first tunneling layer is formed of an amorphous area where an amorphous portion having the amorphous structure is wider than a crystalline portion having a crystalline structure.

3. The method according to claim 1 or 2, wherein at least one of the following is fulfilled:
wherein the metal oxide layer of the first conductive region comprises a binary metal oxide;
wherein the first conductive region is formed by an atomic layer deposition (ALD) or a physical vapor deposition (PVD) in the forming of the first conductive region; or
wherein the forming of the first electrode is performed at a temperature of 400°C or less.

4. The method according to any one of the preceding claims, further comprising:
forming a second conductive region for extracting a carrier having a polarity opposite to a carrier extracted by the first conductive region, wherein the second conductive region comprises the metal oxide layer having the amorphous structure,
wherein a first process temperature of the forming of the first conductive region and a second process temperature of the forming of the second conductive region are different from each other, and
wherein the second conductive region is formed after the first conductive region is formed when the first process temperature is higher than the second process temperature, while the first conductive region is formed after the second conductive region is formed when the second process temperature is higher than the first process temperature.

5. The method according to any one of the preceding claims, wherein the first conductive region is formed to include a first portion and a second portion in the forming of the first conductive region, wherein each the first portion and the second portion includes the metal oxide layer while the first portion and second portion have compositions different from each other,
wherein the forming of the first conductive region comprises:
a first process for forming the first portion adjacent to the first tunneling layer; and
a second process for forming the second portion adjacent to the first electrode,
wherein a process condition of the first process is different from a process condition of the second process, and a first oxygen ratio which is a ratio of oxygen to a metal in the first portion is different from a second oxygen ratio which is a ratio of oxygen to the metal in the second portion.

6. The method according to claim 5, wherein the second oxygen ratio is less than the first oxygen ratio,
wherein the first conductive region is formed by an atomic layer deposition (ALD) in the forming of the first conductive region, and the forming of the first conductive region comprises:
supplying a first raw material containing oxygen;
purging the first raw material;
supplying a second raw material containing a metal; and
purging the second raw material, and
wherein at least one of a supply time, a supply amount, a concentration, and a total supplying process number of the first raw material is less in the second process than in the first process; or
wherein at least one of a purge time and a total purge number of the first raw material is greater in the second process than in the first process; or
wherein at least one of the supply time, the supply amount, the concentration, and the total supplying process number of the second raw material is greater in the second process than in the first process; or
wherein at least one of the purge time and the total purge number of the second raw material is less in the second process than in the first process.

7. The method according to any one of the preceding claims, wherein the first tunneling layer comprises a silicon oxide layer, and
wherein the forming of the first tunneling layer and the forming of the first conductive region are performed by an in-situ process that is continuously performed in the same apparatus.

8. The method according to claim 7, wherein the silicon oxide layer is formed by a process of supplying ozone to the semiconductor substrate at a temperature of 400°C or less in the forming of the first tunneling layer, and
wherein the ozone is supplied in a gaseous state, and
wherein a semiconductor-including material or a hydrogen-including material is supplied when the ozone is supplied to form the silicon oxide layer in the forming of the first tunneling layer.

9. The method according to claim 7 or 8, wherein the first tunneling layer is formed of the silicon oxide layer between the semiconductor substrate and the first conductive region to be in contact with the semiconductor substrate and the first conductive region, or
wherein the first tunneling layer comprises the silicon oxide layer and another portion formed by a process different from a process of forming the silicon oxide layer and having a material different from the silicon oxide layer.

10. A solar cell, comprising:
a semiconductor substrate;
a tunneling layer located on one surface of the semiconductor substrate;
a first conductive region for extracting a first carrier on the tunneling layer; and
a first electrode electrically connected to the first conductive region,
wherein the first conductive region comprises a metal oxide layer having an amorphous structure.

11. The solar cell according to claim 10, wherein at least an interfacial portion of the first conductive region adjacent to the tunneling layer is formed of an amorphous area where an amorphous portion having the amorphous structure is wider than a crystalline portion having a crystalline structure.

12. The solar cell according to claim 10 or 11, wherein the metal oxide layer of the first conductive region comprises a binary metal oxide; or
wherein a thickness of the amorphous area is 1 nm or more; or
wherein a ratio of the thickness of the amorphous area to a total thickness of the first conductive region is 0.2 to 1.

13. The solar cell according to claim 11 or 12, wherein the amorphous area is formed entirely in a thickness direction of the first conductive region.

14. The solar cell according to any one of claims 10 to 13, wherein the first conductive region comprises a first portion and a second portion having compositions different from each other, and
wherein the first portion is adjacent to the tunneling layer,
wherein the second portion is adjacent to the first electrode, and
wherein a first oxygen ratio which is a ratio of oxygen to a metal in the first portion is greater than a second oxygen ratio which is a ratio of oxygen to the metal in the second portion.

15. The solar cell according to any one of claims 10 to 14, wherein the tunneling layer comprises a silicon oxide layer,
wherein a thickness of a phase transition region formed adjacent to the semiconductor substrate and in the silicon oxide layer is 0.5 nm or less, and wherein the silicon oxide layer comprises hydrogen.
